(19) Europäisches Patentamt
European Patent Office
Office européen des brevets

(11) **EP 2 284 883 A1**

(12) **EUROPEAN PATENT APPLICATION**
published in accordance with Art. 153(4) EPC

(43) Date of publication:
**16.02.2011 Bulletin 2011/07**

(51) Int Cl.:
***H01L 23/36*** (2006.01)  ***H01L 23/12*** (2006.01)

(21) Application number: **09736074.7**

(22) Date of filing: **24.04.2009**

(86) International application number:
**PCT/JP2009/058177**

(87) International publication number:
**WO 2009/131217 (29.10.2009 Gazette 2009/44)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **25.04.2008 JP 2008114905
27.06.2008 JP 2008168147
30.07.2008 JP 2008195978**

(71) Applicant: **Kyocera Corporation
Kyoto-shi
Kyoto 612-8501 (JP)**

(72) Inventors:
• **ABE, Yuichi
Kirishima-shi
Kagoshima 899-4396 (JP)**

• **ISHIMINE, Yuusaku
Kirishima-shi
Kagoshima 899-4396 (JP)**
• **NAKAO, Yuuya
Kirishima-shi
Kagoshima 899-4396 (JP)**
• **NAKAMURA, Kiyotaka
Kirishima-shi
Kagoshima 899-4396 (JP)**
• **MORIYAMA, Masayuki
Kirishima-shi
Kagoshima 899-4396 (JP)**

(74) Representative: **HOFFMANN EITLE
Patent- und Rechtsanwälte
Arabellastraße 4
81925 München (DE)**

(54) **HEAT DISSIPATING BASE BODY AND ELECTRONIC DEVICE USING THE SAME**

(57) In a conventional heat dissipating base body, when a supporting substrate and a circuit member are joined, the supporting substrate is greatly warped. In order to solve this problem, there is provided a heat dissipating base body (1) including a supporting substrate (2) having a first main surface and a second main surface facing the first main surface, a first intermediate layer located on the first main surface, a second intermediate layer located on the second main surface, a circuit member (22) located on the first intermediate layer, and a heat dissipating member (23) located on the second intermediate layer, at least one of the first intermediate layer and the second intermediate layer having an inner layer (31, 32) and an outer layer (41, 42) located away from the inner layer (31, 32) to the supporting substrate (2), and the inner layer (31, 32) having a melting point lower than that of the outer layer (41, 42).

FIG. 1

EP 2 284 883 A1

## Description

Technical Field

Electronic components include semiconductor elements such as an insulated gate bipolar transistor (IGBT) element, a metal-oxide semiconductor yield-effect transistor (MOSFET) element, a light-emitting diode (LED) element, a free wheeling diode (FWD) element or a giant transistor (GTR) element, sublimation type thermal printer head elements and thermal inkjet printer head elements. The present invention relates to a heat dissipating base body on which those electronic components are mounted.
The invention further relates to an electronic device comprising the heat dissipating base body and those electronic components mounted thereon.

Background Art

A heat dissipating base body used in an electronic device is constituted by, for example, joining a copper plate as a circuit member to one main surface of a ceramic substrate and joining a copper plate as a heat dissipating member having good heat dissipating properties to another main surface thereof. Heatsink for further diffusing heat generated in an electronic component such as a semiconductor element is generally attached to the copper plate as a heat dissipating member.

Such a heat dissipating base body is proposed in, for example, Patent literatures 1 to 3 mentioned below. However, great warpage may be generated in a ceramic substrate due to difference in coefficient of thermal expansion between the ceramic substrate and the copper plate. For this reason, a substrate being difficult to cause warpage and having good heat dissipating characteristics is desired.

Citation List

Patent literature

Patent literature 1: Japanese Unexamined Patent Publication JP-A 5-148053 (1993)
Patent literature 2: Japanese Unexamined Patent Publication JP-A 9-69590 (1997)
Patent literature 3: Japanese Unexamined Patent Publication JP-A 5-90444 (1993)

Summary of Invention

A heat dissipating base body according to one embodiment of the invention comprises a supporting substrate having a first main surface and a second main surface facing the first main surface, a first intermediate layer located on the first main surface, a second intermediate layer located on the second main surface, a circuit member located on the first intermediate layer, and a heat dissipating member located on the second intermediate layer, at least one of the first intermediate layer and the second intermediate layer having an inner layer and an outer layer located away from the inner layer to the supporting substrate, and the inner layer having a melting point lower than that of the outer layer.

An electronic device according to one embodiment of the invention comprises the heat dissipating base body mentioned above and an electronic component mounted on the circuit member of the heat dissipating base body.

Brief Description of Drawings

Fig. 1 is a plan view showing a heat dissipating base body according to one embodiment of the invention, planarly seen from a circuit member side thereof;
Fig. 2 is a cross-sectional view taken along the line A-A;
Fig. 3 is an enlarged view of section B of Fig. 2;
Fig. 4 is a bottom view showing the heat dissipating base body according to one embodiment of the invention, planarly seen from a heat dissipating member side thereof;
Fig. 5 is a bottom view showing a heat dissipating base body according to one embodiment of the invention, planarly seen from the heat dissipating member side thereof;
Fig. 6 is an enlarged view showing a modification example in section B of Fig. 2;

Fig. 7 is an enlarged view showing a modification example in section B of Fig. 2;

Fig. 8 is a plan view of an electronic device according to one embodiment of the invention;

Fig. 9 is a plan view showing a heat dissipating base body according to one embodiment of the invention, planarly seen from a circuit member side thereof;

Fig. 10 is a cross-sectional view taken along the line A-A;

Fig. 11 is an enlarged view of section B in Fig. 10;

Fig. 12 is a bottom view showing a heat dissipating base body according to one embodiment of the invention, planarly seen from a heat dissipating member side thereof;

Fig. 13 is an enlarged view showing a modification example in section B of Fig. 10;

Fig. 14 is a cross-sectional view showing a modification example in the cross-section taken along the line A-A of Fig. 9;

Fig. 15 is an enlarged view showing a modification example in section B of Fig. 10;

Fig. 16 is a plan view showing a heat dissipating base body according to one embodiment of the invention, planarly seen from a circuit member side thereof;

Fig. 17 is a bottom view showing a heat dissipating base body according to one embodiment of the invention, planarly seen from a heat dissipating member side thereof;

Fig. 18 is a plan view showing a heat dissipating base body according to one embodiment of the invention, planarly seen from a circuit member side thereof;

Fig. 19 is a bottom view showing a heat dissipating base body according to one embodiment of the invention, planarly seen from a heat dissipating member side thereof;

Fig. 20 is a plan view showing a heat dissipating base body according to one embodiment of the invention, planarly seen from a circuit member side thereof;

Fig. 21 is a bottom view showing a heat dissipating base body according to one embodiment of the invention, planarly seen from a heat dissipating member side thereof;

Fig. 22 is a plan view showing a heat dissipating base body according to one embodiment of the invention, planarly seen from a circuit member side thereof;

Fig. 23 is a cross-sectional view taken along the line A-A of Fig. 22;

Fig. 24 is an enlarged view of section B in Fig. 23;

Fig. 25 is a bottom view showing a heat dissipating base body according to one embodiment of the invention, planarly seen from a heat dissipating member side thereof;

Fig. 26 is a plan view showing a heat dissipating base body according to one embodiment of the invention, planarly seen from a circuit member side thereof;

Fig. 27 is a bottom view showing a heat dissipating base body according to one embodiment of the invention, planarly seen from a heat dissipating member side thereof;

Fig. 28 is a plan view showing a heat dissipating base body according to one embodiment of the invention, planarly seen from a circuit member side thereof;

Fig. 29 is a cross-sectional view taken along the line A-A of Fig. 28;

Fig. 30 is a bottom view showing a heat dissipating base body according to one embodiment of the invention, planarly seen from a heat dissipating member side thereof;

Fig. 31 is a plan view showing a heat dissipating base body according to one embodiment of the invention, planarly seen from a circuit member side thereof;

Fig. 32 is a cross-sectional view taken along the line A-A of Fig. 28;

Fig. 33 is a bottom view showing a heat dissipating base body according to one embodiment of the invention, planarly seen from a heat dissipating member side thereof;

Fig. 34 is a plan view showing a heat dissipating base body according to one embodiment of the invention, planarly seen from a circuit member side thereof;

Fig. 35 is a cross-sectional view taken along the line A-A of Fig. 34;

Fig. 36 is a bottom view showing a heat dissipating base body according to one embodiment of the invention, planarly seen from a heat dissipating member side thereof;

Fig. 37 is a plan view showing a heat dissipating base body according to one embodiment of the invention, planarly seen from a circuit member side thereof;

Fig. 38 is a cross-sectional view taken along the line A-A of Fig. 37;

Fig. 39 is a bottom view showing a heat dissipating base body according to one embodiment of the invention, planarly seen from a heat dissipating member side thereof;

Fig. 40 is a plan view showing a heat dissipating base body according to one embodiment of the invention, planarly seen from a circuit member side thereof;

Fig. 41 is a cross-sectional view taken along the line A-A of Fig. 40;

Fig. 42 is a bottom view showing a heat dissipating base body according to one embodiment of the invention, planarly seen from a heat dissipating member side thereof;

Fig. 43 is a plan view showing a supporting substrate constituting a heat dissipating base body according to one embodiment of the invention, planarly seen from an upper side thereof;
Fig. 44 is a cross-sectional view taken along the line A-A of Fig. 43;
Fig. 45 is a cross-sectional view taken along the line C-C of Fig. 43;
Fig. 46 is an enlarged view of section B of Fig. 44;
Fig. 47 is a cross-sectional view showing a modification example in a cross-section taken along the line C-C of Fig. 43;
Fig. 48 is a plan view showing a supporting substrate constituting a heat dissipating base body according to one embodiment of the invention, planarly seen from an upper side thereof;
Fig. 49 is a cross-sectional view taken along the line A-A of Fig. 48;
Fig. 50 is a cross-sectional view taken along the line C-C of Fig. 48;
Fig. 51 is an enlarged view of section B of Fig. 49;
Fig. 52 is a cross-sectional view showing a modification example in cross-section taken along the line C-C of Fig. 48;
Fig. 53 is a plan view showing a supporting substrate constituting a heat dissipating base body according to one embodiment of the invention, planarly seen from an upper side thereof;
Fig. 54 is a cross-sectional view taken along the line A-A of Fig. 53;
Fig. 55 is a cross-sectional view taken along the line C-C of Fig. 53;
Fig. 56 is a plan view showing a supporting substrate constituting a heat dissipating base body according to one embodiment of the invention, planarly seen from an upper side thereof;
Fig. 57 is a cross-sectional view taken along the line A-A of Fig. 56; and
Fig. 58 is a cross-sectional view taken along the line C-C of Fig. 56.

Description of Embodiments

Embodiments of the invention is described below by referring to the drawings. First of all, the embodiment of a heat dissipating base body is described below.

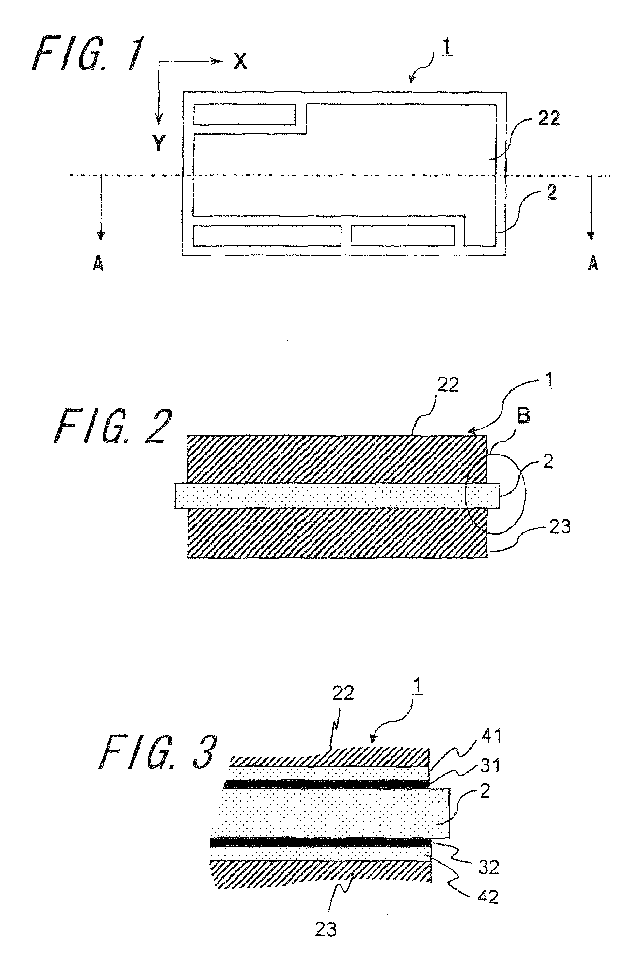

As shown in Figs. 1 to 4, a heat dissipating base body 1 comprises a supporting substrate 2 having a first main surface and a second main surface facing the first main surface, a first intermediate layer located on the first main surface, a second intermediate layer located on the second main surface, a circuit member 22 located on the first intermediate layer, and a heat dissipating member 23 located on the second intermediate layer, and at least one of the first intermediate layer and the second intermediate layer has inner layers 31 and 32 and outer layers 41 and 42 located away from the inner layers 31 and 32 to the supporting substrate 2. In other words, the heat dissipating base body 1 comprises the supporting substrate 2 having at least the first intermediate layer and the circuit member 22 laminated on the first main surface thereof in this order and having at least the second intermediate layer and the heat dissipating member 23 laminated on the second main surface thereof facing the first main surface in this order. Specifically, as shown in Fig. 3, at least the inner layer 31 and the outer layer 41, constituting the first intermediate layer are laminated on the first main surface of the supporting substrate 2 in this order, and the circuit member 2 is provided on those layers. On the other hand, at least the inner layer 32 and the outer layer 42, constituting the second intermediate layer are laminated on the second main surface facing the first main surface of the supporting substrate 2 in this order, and the heat dissipating member 23 is further laminated. At least one of the first intermediate layer and the second intermediate layer has a two-layer structure composed of the inner layers 31 and 32 and the outer layers 41 and 42 laminated in this order, respectively, from the supporting substrate 2 side, and the inner layers 31 and 32 have a melting point lower than that of the outer layers 41 and 42.

The inner layers 31 and 32 contain one or more elements selected from titanium, zirconium, hafnium and niobium, although not a main component, and are a layer having a melting point lower than that of the outer layers 41 and 42 as a whole. Specifically, the inner layers 31 and 32 comprise, for example, a silver (Ag-)-copper (Cu) alloy containing one or more selected from titanium, zirconium, hafnium and niobium. The outer layers 41 and 42 contain one or more selected from gold, silver, copper, nickel, cobalt and aluminum as a main component, and are a layer having a melting point higher than that of the inner layers 31 and 32 as a whole. The outer layers 41 and 42 are a layer for strongly bonding the inner layers 31 and 32, and the circuit member 22 and the heat dissipating member 23, respectively. The term "main component" used herein means a component occupying 50% by mass or more of 100% by mass of the whole components constituting a layer. This proportion can be obtained by fluorescent X-ray spectroscopy or ICP (Inductivity Coupled Plasma) emission spectroscopy.

The above configuration can form the circuit member 22 and the heat dissipating member 23 on the outer layers 41 and 42, respectively, at low temperature of, for example, 50°C or higher and 100°C or lower. In addition, heat stress generated in this formation is absorbed by the outer layers 41 and 42, and as a result, warpage generated in the supporting substrate 2 is decreased. This can increase thicknesses of the circuit member 22 and the heat dissipating member 23. The heat dissipating base body 1 having thick circuit member 22 and heat dissipating member 23 has high heat dissipating characteristics, and this can make heatsink unnecessary.

The outer layers 41 and 42 preferably comprise nickel as a main component, and the amount of nickel is preferably 90% by mass or more, and particularly preferably 99% by mass or more. The reason for this is that the outer layers 41 and 42 have lower electric resistance and higher thermal conductivity as the amount of nickel contained is increased, resulting in excellent circuit characteristics (characteristics of inhibiting generation of heat of electronic components and reducing electrical power loss) and heat dissipating characteristics. Furthermore, a dense layer is formed as the amount of nickel contained is increased. As a result, airspace such as pore is difficult to be generated among the outer layers 41 and 42, the circuit member 22, the heat dissipating member 23, and inner layers 31 and 32, resulting in improvement of reliability.

When the outer layers 41 and 42 comprise nickel as a main component, the inner layers 31 and 32 preferably comprise a silver (Ag)-copper (Cu) alloy containing one or more selected from titanium, zirconium, hafnium and niobium. The reason for this is that nickel has high adhesion to silver (Ag) and copper (Cu).

It is preferred that a reaction layer formed by the reaction between a metal contained in the inner layers 31 and 32 and a metal contained in the outer layers 41 and 42 is not substantially present between the inner layers 31 and 32 and the outer layers 41 and 42, respectively. The reason for this is that if such a reaction layer is not substantially present, residual stress generated in the supporting substrate 2 can be decreased, making it possible to form the heat dissipating base body 1 having suppressed warpage. The term "the state that a reaction layer is not present" used herein means the state that a layer containing a eutectic alloy or a hypoeutectic alloy, comprising a metal contained in the inner layers 31 and 32 and a metal contained in the outer layers 41 and 42 is not present at each interface between the inner layers 31 and 32 and the outer layers 41 and 42, respectively. Whether or not a eutectic alloy or a hypoeutectic alloy is present can be confirmed by the presence or absence of a diffraction peak using, for example, X-ray diffraction method.

The heat dissipating base body 1 of the present embodiment is preferably configured such that the inner layers 31 and 32 contain molybdenum. When the inner layers 31 and 32 are formed by a brazing material containing one or more selected from titanium, zirconium, hafnium and niobium, and molybdenum, molybdenum has a high melting point and is difficult to melt. As a result, viscosity of the brazing material in a joining step is increased. Therefore, even though the brazing material is applied to the supporting substrate 2, the brazing material is difficult to spread on the surface thereof. This can adjust a shape of the inner layers 31 and 32 with relatively good precision.

The heat dissipating base body 1 of the present embodiment is preferably configured such that the circuit member 22 and the heat dissipating member 23 comprise copper or an alloy thereof, or aluminum or an alloy thereof. The reason for this is that those metals each are materials having high thermal conductivity, heat generated from electronic components such as a semiconductor element mounted on the circuit member 22 immediately spreads, and as a result, heat dissipating characteristics can be enhanced. Particularly, the circuit member 22 and the heat dissipating member 23 are preferably configured such that the content of copper is 80% by mass or more. Furthermore, the circuit member 22 and the heat dissipating member 23 each desirably have a volume inherent resistance of $5 \times 10^{-8}$ $\Omega$·m or less, and particularly $3 \times 10^{-8}$ $\Omega$·m or less.

The supporting substrate 2 preferably comprises ceramic comprising silicon nitride or aluminum nitride as a main component. The ceramics may be either a sintered compact or a single crystalline body. When the supporting substrate 2 comprises ceramics comprising silicon nitride or aluminum nitride as a main component, silicon nitride and aluminum nitride have a high thermal conductivity of 40 W/(m·K) or more and 150 W/(m·K) or more, respectively. As a result, a heat dissipating base body having high heat dissipating characteristics and reliability can be formed. The term "main component" used herein means a component occupying 50% by mass or more of 100% by mass of the whole components constituting the supporting substrate 2. This proportion can be obtained by fluorescent X-ray spectroscopy or ICP emission spectroscopy. When the main component of the supporting substrate 2 is silicon nitride, the proportion of silicon nitride can be obtained by obtaining silicon by the above method, and converting the proportion to nitride. When the main component of the supporting substrate 2 is aluminum nitride, the proportion of aluminum nitride can be obtained by obtaining the proportion of aluminum by the above method and converting the proportion to nitride.

Particularly, when the supporting substrate 2 comprises ceramics comprising silicon nitride as a main component, the silicon nitride is preferably contained in an amount of 80% by mass or more. Erbium oxide, magnesium oxide, silicon oxide, molybdenum oxide, aluminum oxide and the like may be contained as other addition ingredients.

Mechanical characteristics of the supporting substrate 2 are preferably such that three-point bending strength is 500 MPa or more, Young's modulus is 300 GPa or more, Vickers hardness (Hv) is 13 GPa or more, and fracture toughness ($K_{1C}$) is 5 MPam$^{1/2}$ or more. This makes it possible to use the heat dissipating base body 1 over a long period of time owing to those characteristics when the heat dissipating base body 1 is constituted, and when the mechanical characteristics fall in the above ranges, reliability can be improved. In particular, creep resistance and durability to heat cycle can be improved.

The three-point bending strength may be obtained by removing the inner layers 31 and 32, the outer layers 41 and 42, the circuit member 22 and the heat dissipating member 23 from the heat dissipating base body 1 by etching, and then conducting measurement according to JIS R 1601-1995. In the case that the thickness of the supporting substrate 2 is small and the test piece cut off from the supporting substrate 2 cannot have a thickness of 3 mm, the thickness of the supporting substrate 2 is evaluated as a thickness of the test piece, and it is preferred that the result satisfies the above numerical value.

Young's modulus may be obtained by removing the inner layers 31 and 32, the outer layers 41 and 42, the circuit member 22 and the heat dissipating member 23 from the heat dissipating base body 1 by etching, and then conducting measurement according to an indentation fracture method (IF method) defined in JIS R 1602-1995.
In the case that the thickness of the supporting substrate 2 is small and the test piece cut off from the supporting substrate 2 cannot have a thickness of 4 mm, the thickness of the supporting substrate 2 is evaluated as a thickness of the test piece, and it is preferred that the result satisfies the above numerical value.

Vickers hardness (Hv) and fracture toughness ($K_{1C}$) may be measured according to JIS R 1610-2003 and JIS R 1607-1995, respectively.

Electrical characteristics of the supporting substrate 2 are preferably such that a volume inherent resistance is $10^{12}$ $\Omega \cdot$m or more at ordinary temperature and $10^{10}$ $\Omega \cdot$m or more at 300°C. Leakage of current from the circuit member 22 side to the heat dissipating member 23 side during the operations of various electronic components such as semiconductor element can be inhibited by the supporting substrate 2. This can prevent electric power loss from being generated, and additionally can reduce electronic device malfunction.

The supporting substrate 2 has, for example, a length in X axis direction shown in Fig. 1 of 30 mm or more and 80 mm or less and a length in Y axis direction of 10 mm or more and 80 mm or less. Although a thickness of the supporting substrate 2 differs depending on the applications, when the thickness is too large, thermal resistance is increased, and when the thickness is too small, durability is decreased. Therefore, the thickness is preferably 0.25 mm or more and 0.65 mm or less.

The inner layers 31 and 32 have, for example, a length in X axis direction and Y axis direction per one layer of 2 mm or more and 76 mm or less, respectively, and have a thickness of 10 $\mu$m or more and 60 $\mu$m or less. The outer layers 41 and 42 have the same size as that of the inner layers 31 and 32.

The circuit member 22 has, for example, a length in X axis direction and Y axis direction per one member of 1.8 mm or more and 75.6 mm or less, respectively, and the thickness is selected from a range of 0.2 mm or more and 1.5 mm or less according to magnitude of electric current flowing through a circuit and the amount of heat generation of an electronic component such as a semiconductor element mounted on the circuit member 22. The heat dissipating member 23 has a function of allowing heat generated in an electronic component to escape, and has, for example, a length in X axis direction and Y axis direction per one member of 1.8 mm or more and 77.6 mm or less, and a thickness of 0.2 mm or more and 1.5 mm or less.

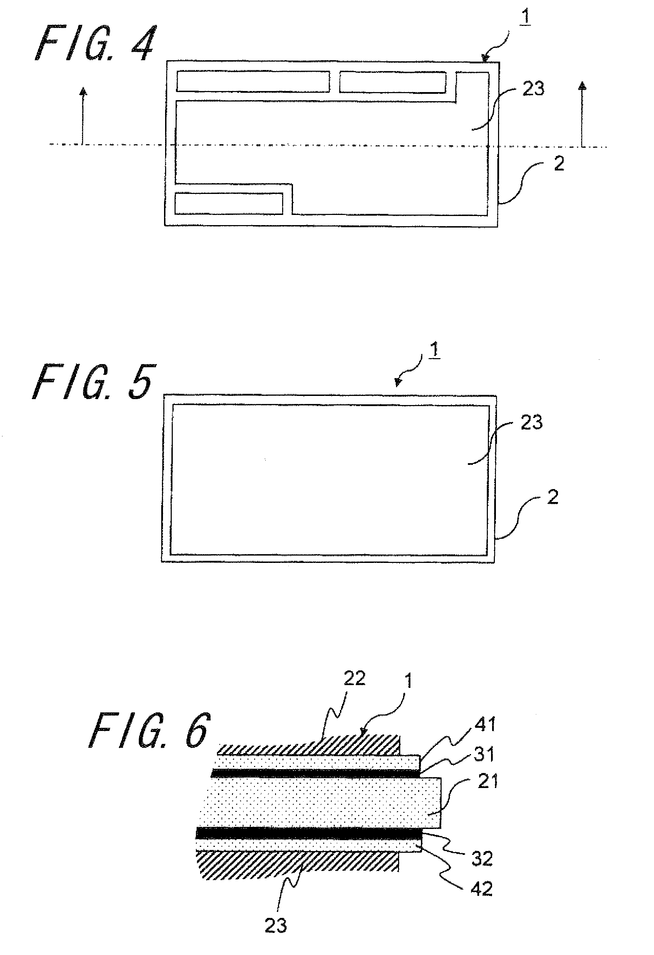

Various embodiments of the heat dissipating base body are described using Figs. 5 to 7. As to reference numerals in the drawings, the same members as in Figs. 1 to 4 will be denoted by the same reference numerals.

As shown in Fig. 5, the heat dissipating base body 1 may has the heat dissipating member 23 larger than the circuit member 22. According to this heat dissipating base body 1, heat generated in an electronic component such as a semiconductor element mounted thereon can efficiently be diffused.

As shown in Fig. 6, each edge surface of the inner layers 31 and 32 may be located further outward than each edge surface of the circuit member 22 and the heat dissipating member 23, respectively, in the X axis direction of Fig. 1. According to this heat dissipating base body 1, even when heat history is applied to the supporting substrate 1, heat stress generated by difference in coefficient of thermal expansion between the circuit member 22 and the supporting substrate 2 and between the heat dissipating member 23 and the supporting substrate 2 is liable to diffuse in the inner layers 31 and 32. As a result, cracks are difficult to occur in the supporting substrate 2, and reliability can be improved. Even in the Y axis direction of Fig. 1, each edge surface of the inner layers 31 and 32 may be located further outward than each edge surface of the circuit member 22 and the heat dissipating member 23, respectively.

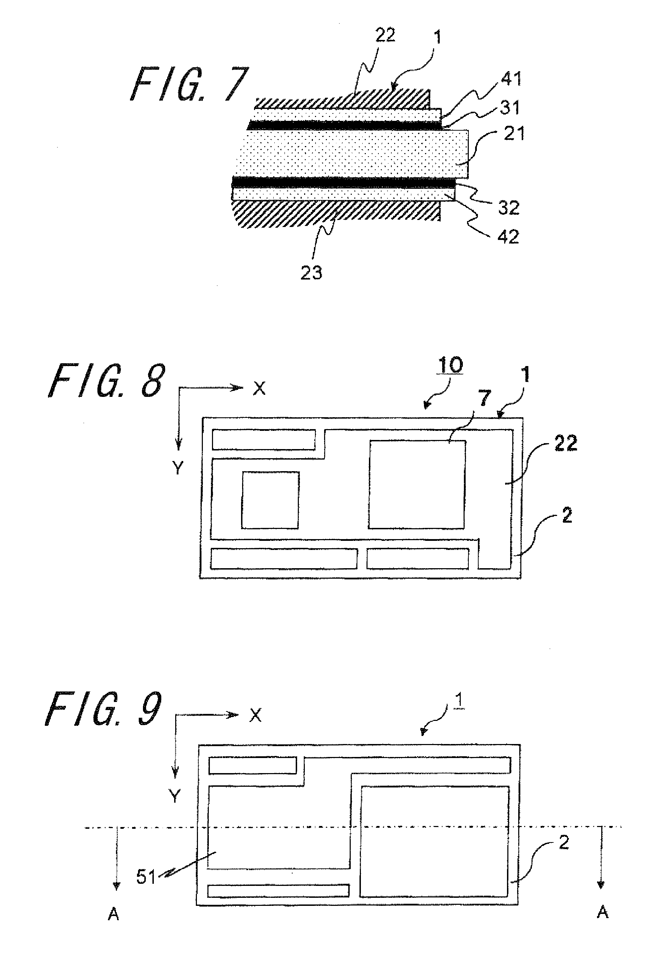

As shown in Fig. 7, in X axis direction of Fig. 1, each edge surface of the inner layers 31 and 32 may be located further outward than each edge surface of the circuit member 22 and the heat dissipating member 23, respectively, and the heat dissipating member 23 may be larger than the circuit member 22. In this heat dissipating base body 1, even when heat history is applied to the supporting substrate 1, heat stress generated by difference in coefficient of thermal expansion between the circuit member 22 and the supporting substrate 2 and between the heat dissipating member 23 and the supporting substrate 2 is liable to diffuse in the inner layers 31 and 32. As a result, cracks are difficult to occur in the supporting substrate 2, and reliability can be improved. Furthermore, when the heat dissipating member 23 is larger than the circuit member 22, heat generated in an electronic component (not shown) such as a semiconductor element can efficiently be diffused.

In the embodiment of Fig. 7, when a plurality of the heat dissipating members 23 are used as shown in Fig. 4, warpage of the heat dissipating members 23 can further be reduced as compared with the embodiment that a single heat dissipating member 23 is used as shown in Fig. 5.

The heat dissipating base body 1 of the invention is preferably configured such that warpage of the main surface of the supporting substrate 2 at the heat dissipating member 23 side to a long side is 0.3% or less, and the warpage is convex toward the heat dissipating member 23. When heatsink (not shown) for further diffusing heat is attached to the back side of the heat dissipating member 23, contact area to the heatsink is increased, and heat is easily to escape in the heatsink. As a result, heat dissipating characteristics can further be improved.

One example of a production method of the heat dissipating base body 1 described above is described below. The supporting substrate 2 comprising ceramics comprising, for example, silicon nitride or aluminum nitride as a main component, having a length in X axis direction of 30 mm or more and 80 mm or less, a length in Y direction of 10 mm or more and 80 mm or less and a thickness of 0.25 mm or more and 0.65 mm or less in Fig. 1 was prepared. Paste of a silver (Ag)-copper (Cu) alloy containing one or more selected from titanium, zirconium, hafnium and niobium is applied to both main surfaces of the supporting substrate 2 by any one of screen printing, roll coater method and brush coating, followed by heating at 800°C or higher and 900°C or lower, thereby forming the inner layers 31 and 32.

When the inner layers 31 and 32 contain molybdenum, paste of a silver (Ag)-copper (Cu) alloy containing one or more selected from titanium, zirconium, hafnium and niobium, and molybdenum is applied by any one of screen printing, roll coater method and brush coating, followed by heating at 800°C or higher and 900°C or lower, thereby forming the inner layers 31 and 32.

The outer layers 41 and 42 containing one or more selected from gold, silver, copper, nickel, cobalt and aluminum as a main component are formed on the inner layers 31 and 32 by any one of methods selected from sputtering, vacuum vapor deposition and electroless plating.

Resist films (not shown) are printed on both main surfaces of the supporting substrate 2 by screen printing, and the circuit member 22 and the heat dissipating member 23, comprising copper or an alloy thereof, or aluminum or an alloy thereof are then formed on the both main surfaces of the outer layers 41 and 42 by electrolytic plating or thermal spraying in a thickness of 300 $\mu$m or more and 1000 $\mu$m or less, respectively.

To prevent a reaction layer from being substantially present between the inner layer 31 and the outer layer 41, a metal having a purity of 99.9% by mass or more is used as a metal forming the outer layer 41. Also in the case of preventing a reaction layer from being substantially present between the inner layer 32 and the outer layer 42, a metal having a purity of 99.9% by mass or more is used as a metal forming the outer layer 42.

The resist films are peeled by dipping in an alkaline solution, followed by heat treatment such as annealing. Thus, the heat dissipating base body 1 can be obtained.

The heat dissipating base body 1 obtained above can form the circuit member 22 and the heat dissipating member 23 on the outer layers 41 and 42, respectively, at low temperature of 50°C or higher and 100°C or lower. Furthermore, thermal stress generated in this formation is absorbed in the outer layers 41 and 42 and becomes small. This can increase thicknesses of the circuit member 22 and the heat dissipating member 23. The heat dissipating base body 1 having the thickness of both circuit member 22 and heat dissipating member 23 increased can increase heat dissipating characteristics, and in some cases, heatsink may not be attached.

The electronic device according to one embodiment of the invention has an electronic component 7 mounted on the circuit member 22 in the heat dissipating base body 1 having high heat dissipating characteristics as shown in Fig. 8. This configuration can form an electronic device 10 having high heat dissipating characteristics. The heat dissipating base body 1 has high heat dissipating characteristics, and therefore can be used without almost decreasing heat dissipating efficiency of heat generated in the electronic component 7 over a long period of time. The electronic component 7 includes semiconductor elements such as an insulated gate bipolar transistor (IGBT) element, a metal-oxide semiconductor field-effect transistor (MOSFET) element, a light-emitting diode (LED) element, a free wheeling diode (FWD) element or a giant transistor (GTR) element; semiconductor elements such as sublimation type thermal printer head element and thermal inkjet printer head element; sublimation type thermal printer head elements; and thermal inkjet printer head elements.

The embodiment of the heat dissipating base body in which the inner layer has an oxide of a main component element of the outer layer, and at least one of the circuit member and the heat dissipating member, and the outer layer have the same element as a main component is described below by referring to Figs. 9 to 42.

As shown in Figs. 9 to 12, the heat dissipating base body 1 comprises the insulating supporting substrate 2 having a circuit member 51 located on the first main surface side thereof and a heat dissipating member 52 provided at the second main surface side thereof. The inner layers 31 and 32 and the outer layers 41 and 42 are sequentially laminated toward at least one side of the circuit member 51 and the heat dissipating member 52 from the supporting substrate 2 side. The inner layers 31 and 32 comprise an oxide of the main component element of the outer layers 41 and 42, and at least one of the circuit member 51 and the heat dissipating member 52, and the outer layers 41 and 42 have the same element as a main component.

When the heat dissipating base body 1 is thus constituted, at least one of the circuit member 51 and the heat dissipating member 52, and the outer layers 41 and 42 can be joined at low temperature. Furthermore, when the inner layers 31 and 32 comprise an oxide of the main component element of the outer layers 41 and 42, coefficient of thermal expansion thereof can be reduced to bring it closer to coefficient of thermal expansion of the supporting substrate 2. By those actions, difference between residual stress remaining at the first main surface side and residual stress remaining at the second main surface side is decreased, and warpage generated in the heat dissipating base body 1 as a whole can be decreased. Furthermore, thickness of the heat dissipating member 52 can be increased, making heatsink such as a copper-made heat dissipating plate unnecessary. As a result, a thin plate of a silicone resin interposed between the copper plate and the copper-made heat dissipating plate becomes unnecessary. As a result, thermal resistance due to the silicone resin is not generated, and heat dissipating characteristics of the heat dissipating base body 1 can be improved.

The supporting substrate 2 comprises, for example, ceramics comprising at least any one of silicon nitride, aluminum oxide, aluminum nitride, zirconium oxide and beryllium oxide as a main component. In particular, the supporting substrate 2 has, for example, a length of 30 mm or more and 80 mm or less and a width of 10 mm or more and 80 mm or less. The thickness varies depending on the applications, but is preferably 0.2 mm or more and 1.0 mm or less in order to form the supporting substrate having high durability and dielectric strength voltage and suppressed thermal resistance.

The circuit member 51 has, for example, a length of 5 mm or more and 60 mm or less and a width of 5 mm or more and 60 mm or less. The thickness is determined by magnitude of electric current flowing through the circuit member 51 and amount of heat generation of a semiconductor element mounted on the circuit member 51, and is, for example, 0.5 mm or more and 5 mm or less. The heat dissipating member 52 has, for example, a length of 5 mm or more and 120 mm or less and a width of 5 mm or more and 100 mm or less. The thickness is 0.5 mm or more and 5 mm or less, but varies depending on the necessary heat dissipating characteristics.

The circuit member 51 preferably comprises any one of copper or a copper alloy. The heat dissipating member 52 preferably comprises any one of copper, a copper alloy, a composite comprising a copper-impregnated silicon carbide, a copper-diamond sintered compact, a composite comprising carbon-impregnated copper, a copper-molybdenum alloy and a cooper-tungsten alloy. Particularly, when the circuit member 51 and the heat dissipating member 52 comprise copper as a main component, those members further preferably contain copper in an amount of 99.96% by mass or more.

The outer layers 41 and 42 have the function of strongly bonding the circuit member 51 and the heat dissipating member 52 thereto, respectively. The main component element of the outer layers 41 and 42 is, for example, copper, and the main component element is preferably contained in an amount of 99.96% by mass or more. Specifically, any one of oxygen-free copper, tough pitch copper and phosphorous-deoxidized copper is preferably used. In particular, when oxygen-free copper is used, any one of linear crystal oxygen-free copper, high purity single crystal oxygen-free copper and vacuum melted copper, each having copper content of 99.995% by mass or more is preferably used. The reason for this is that electric resistance is low and thermal conductivity is high, as copper content is increased, resulting in excellent circuit characteristics (characteristics that do not allow an electronic component from generating heat and that reduce power loss) and heat dissipating characteristics. Furthermore, yield stress is decreased and plastic deformation is liable to occur at high temperature, as the copper content is increased. Therefore, joining strength between the outer layers 41 and 42, and the circuit member 51 and the heat dissipating member 52, respectively is increased, and as a result, reliability is further improved.

The inner layers 31 and 32 are provided between the supporting substrate 2 and the circuit member 51, and between the supporting substrate 2 and the heat dissipating member 52, respectively, and have the function of strongly bonding the supporting substrate 2 and the circuit member 51 together, and the supporting substrate 2 and the heat dissipating member 52 together. When the main component element of the outer layers 41 and 42 is copper, the inner layers 31 and 32 preferably comprise copper oxide represented by the compositional formula $Cu_xO$ wherein x is $1.0 \leq x \leq 2.0$.

The heat dissipating base body 1 of the present embodiment has different durability depending on the relative relationship between each thickness of the outer layers 41 and 42 and each thickness of the supporting substrate 2, circuit member 51 and the heat dissipating member 52. The outer layers 41 and 42 preferably have a thickness smaller than that of each of the supporting substrate 2, the circuit member 51 and the heat dissipating member 52. This configuration can relax thermal stress generated in the supporting substrate 2 by the difference in coefficient of thermal expansion among the supporting substrate 2, the inner layers 31 and 32, the outer layers 41 and 42, the circuit member 51 and the heat dissipating member 52, and as a result, the heat dissipating base body 1 can improve durability. In particular, each thickness of the inner layers 31 and 32 is preferably 5 nm or more and 20 nm or less.

The heat dissipating base body 1 of the present embodiment has different thermal characteristics depending on the relative relationship between a thickness of any one of the circuit member 51 and the heat dissipating member 52 and a thickness of at least any one of the supporting substrate 2, the inner layers 31 and 32 and the outer layers 41 and 42. At least one of the circuit member 51 and the heat dissipating member 52 preferably has a thickness larger than that of at least any one of the supporting substrate 2, the inner layers 31 and 32 and the outer layers 41 and 42. By this configuration, the heat dissipating base body 1 can efficiently diffuse heat, and additionally increases heat capacity of the circuit member 51 or the heat dissipating member 52, thereby the heat dissipating base body 1 can have excellent heat dissipating characteristics.

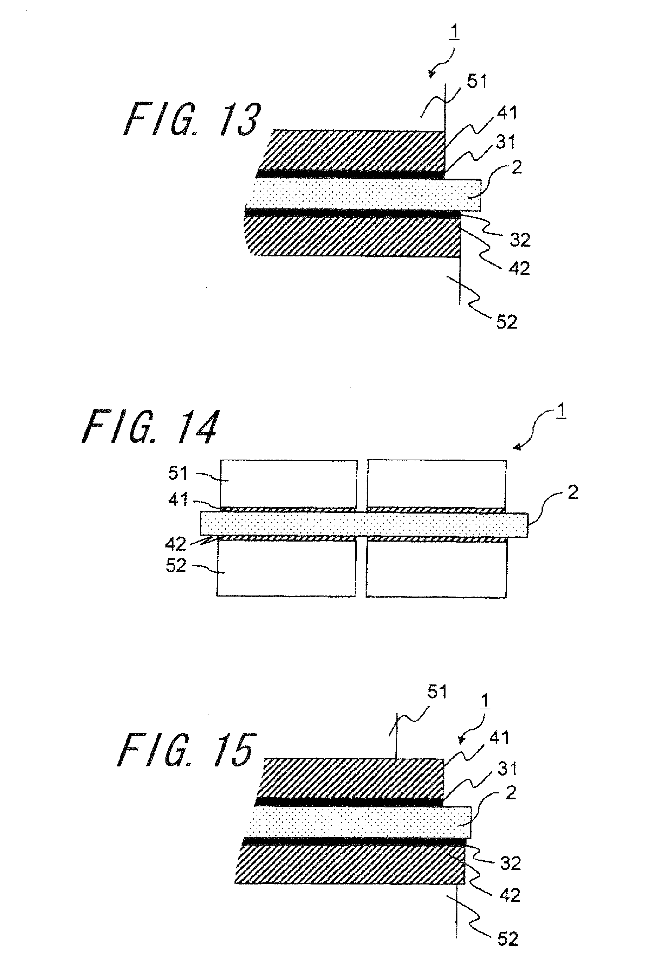

As shown in Fig. 13, at least a part of the edge surface of the heat dissipating member 52 may project outside to the edge surface of the circuit member 51. According to this heat dissipating base body 1, heat generated in an electronic component such as a semiconductor element is liable to diffuse toward the heat dissipating member 52, and as a result, heat dissipating characteristics can further be improved.

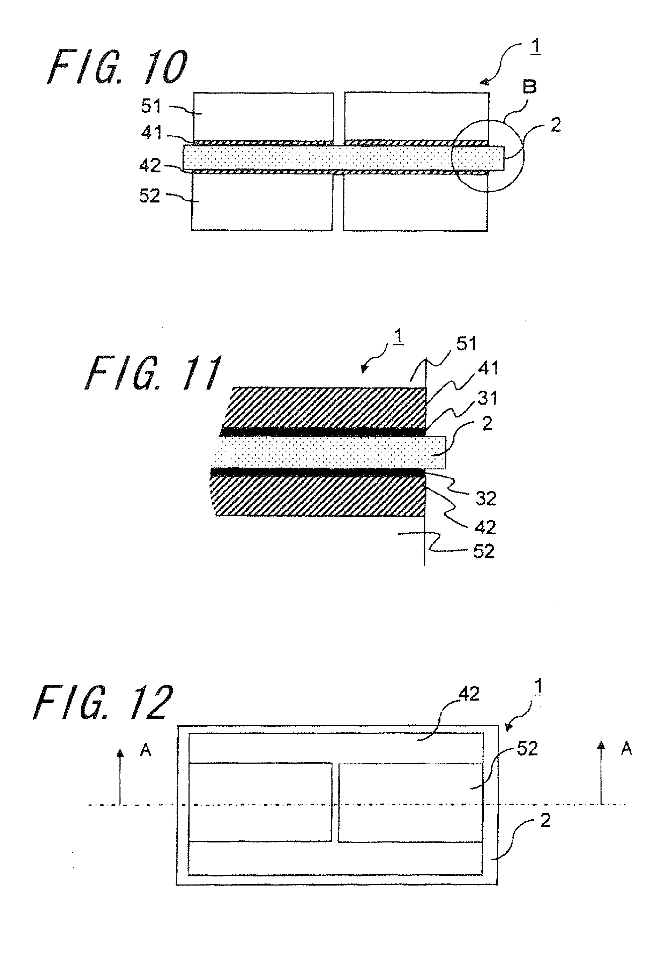

For example, in Fig. 10, warpage of the heat dissipating base body 1 as a whole receives influence by relationship in size between the volume of the heat dissipating member 52 and the volume of the circuit member 51. The heat dissipating base body 1 is preferably configured such that the heat dissipating member 52 has substantially the same volume as that of the circuit member 51. This configuration can make thermal stress generated by the difference in coefficient of thermal expansion between the circuit member 51 and the supporting substrate 2 at the first main surface side of the supporting substrate 2 and thermal stress generated by the difference in coefficient of thermal expansion between the heat dissipating member 52 and the supporting substrate 2 at the second main surface side nearly equal. As a result, warpage becomes small, and durability becomes high. In the present embodiment, the expression that "the heat dissipating member 52 has substantially the same volume as that of the circuit member 51" means that the volume of the heat dissipating member 52 is 0.9 times or more and 1.1 times or less the volume of the circuit member 51.

The heat dissipating base body 1 shown in Fig. 14 is configured such that the heat dissipating member 52 has a volume larger than that of the circuit member 51, and has a large projected area in a plan view. This heat dissipating base body 1 can efficiently diffuse heat generated in an electronic component (not shown) such as a semiconductor element. Additionally, when heatsink (not shown) for the purpose of heat dissipation is joined to the heat dissipating member 52, joined area between the heat dissipating member 52 and the heatsink can be increased, and as a result, heat dissipating characteristics of the heat dissipating base body 1 can further be improved.

The heat dissipating base body 1 shown in Fig. 15 is configured such that at least a part of edge surfaces of the circuit member 51 and the heat dissipating member 52 is located further inward than the edge surfaces of the inner layers 31 and 32 and the outer layers 41 and 42. According to this heat dissipating base body 1, thermal stress applied to the supporting substrate 2, generated by the difference in coefficient of thermal expansion among the supporting substrate 2, the inner layers 31 and 32, the outer layers 41 and 42, the circuit member 51 and the heat dissipating member 52 is more easily dispersed, and as a result, durability can further be improved.

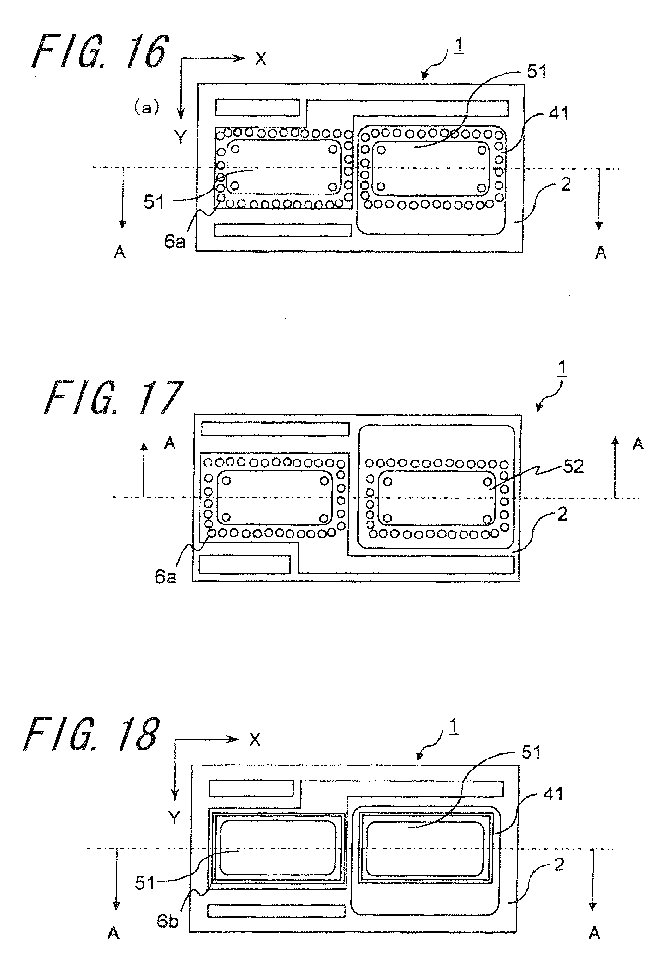

The heat dissipating base body 1 shown in Figs. 16 and 17 is configured such that at least one of the outer layers 41 and 42, the circuit member 51 and the heat dissipating member 52 comprises a through-hole 6a at a part of outer peripheral edge portions thereof. This configuration decreases a volume of the outer peripheral edge portion, and consequently, thermal stress applied to the supporting substrate 2, generated by the difference in coefficient of thermal expansion among the supporting substrate 2, the outer layers 41 and 42, the circuit member 51 and the heat dissipating member 52 is more easily dispersed. As a result, durability can further be improved. A shape of the through-hole 6a may be any of a prismatic shape, a columnar shape, a circular truncated cone shape and a truncated pyramid shape, and through-holes having those plural shapes may be present in a mixed state.

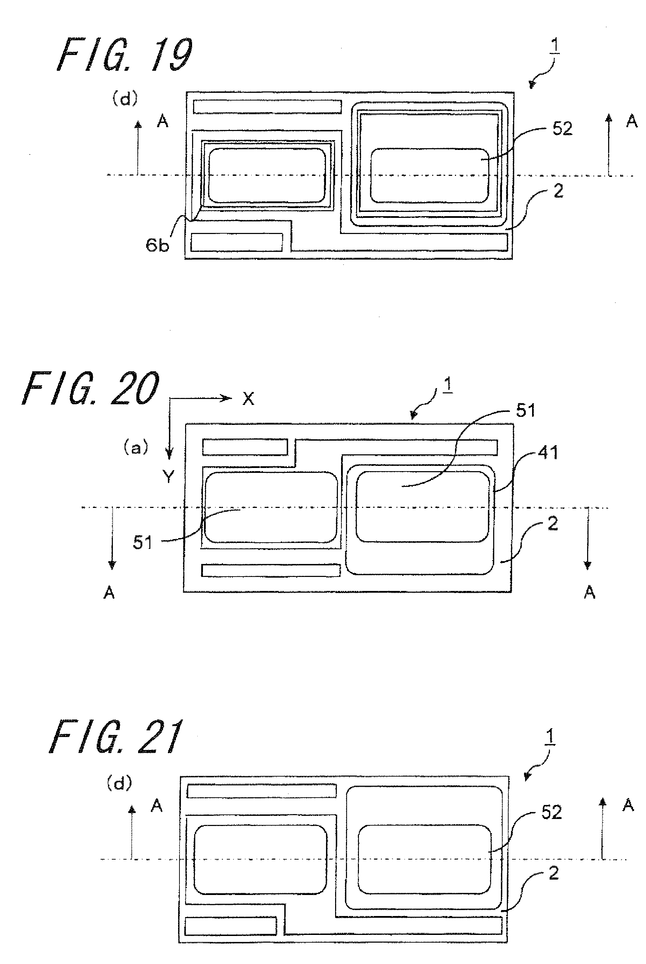

As shown in Figs. 18 and 19, a concave portion 6b may be provided in place of the through-hole 6a in Figs. 16 and 17. Thus, when at least one of the outer layers 41 and 42, the circuit member 51 and the heat dissipating member 52 comprises the concave portion 6b at a part of the outer peripheral edge portions thereof, a volume of the outer peripheral edge portion is decreased. Due to this, thermal stress applied to the supporting substrate 2, generated by the difference in coefficient of thermal expansion among the supporting substrate 2, the outer layers 41 and 42, the circuit member 51 and the heat dissipating member 52 is more easily dispersed. As a result, durability can further be improved. A shape of the concave portion 6b may be such that a cross-section in a longitudinal direction is a curved surface shape, and concave portions having those shapes may be present in a mixed state.

The heat dissipating base body 1 shown in Figs. 20 and 21 is a heat dissipating base body in which at least a part of the outer peripheral edge portions of the inner layers 31 and 32, the outer layers 41 and 42, the circuit member 51 and the heat dissipating member 52 is chamfered. When at least a part of the outer peripheral edge portions of the inner layers 31 and 32, the outer layers 41 and 42, the circuit member 51 and the heat dissipating member 52 is chamfered, a volume of the outer peripheral edge portion is decreased. Due to this, thermal stress applied to the supporting substrate 2, generated by the difference in coefficient of thermal expansion among the supporting substrate 2, the inner layers 31 and 32, the outer layers 41 and 42, the circuit member 51 and the heat dissipating member 52 is more easily dispersed. As a result, durability can further be improved.

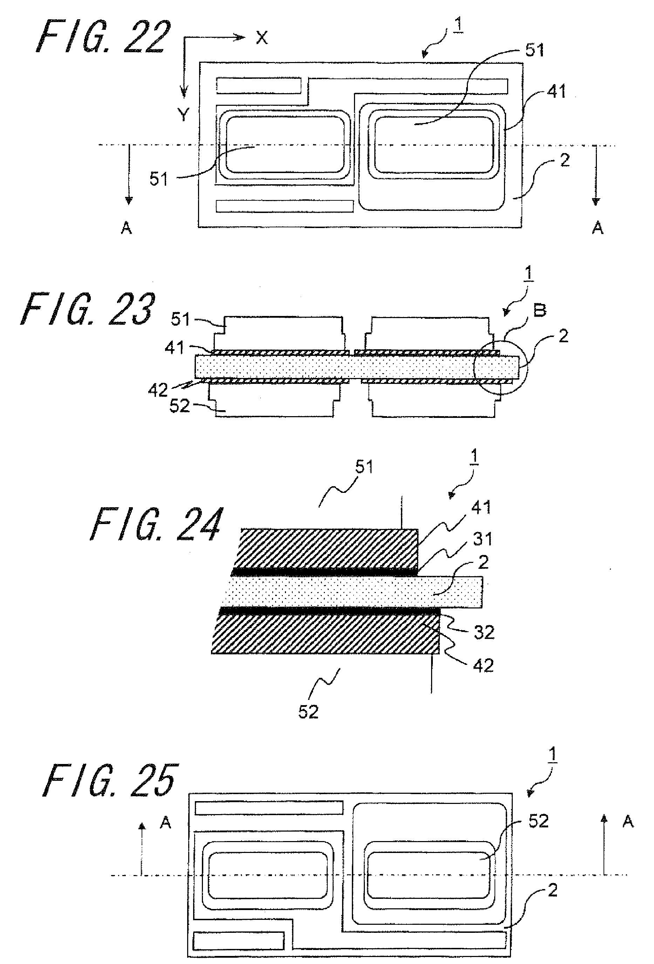

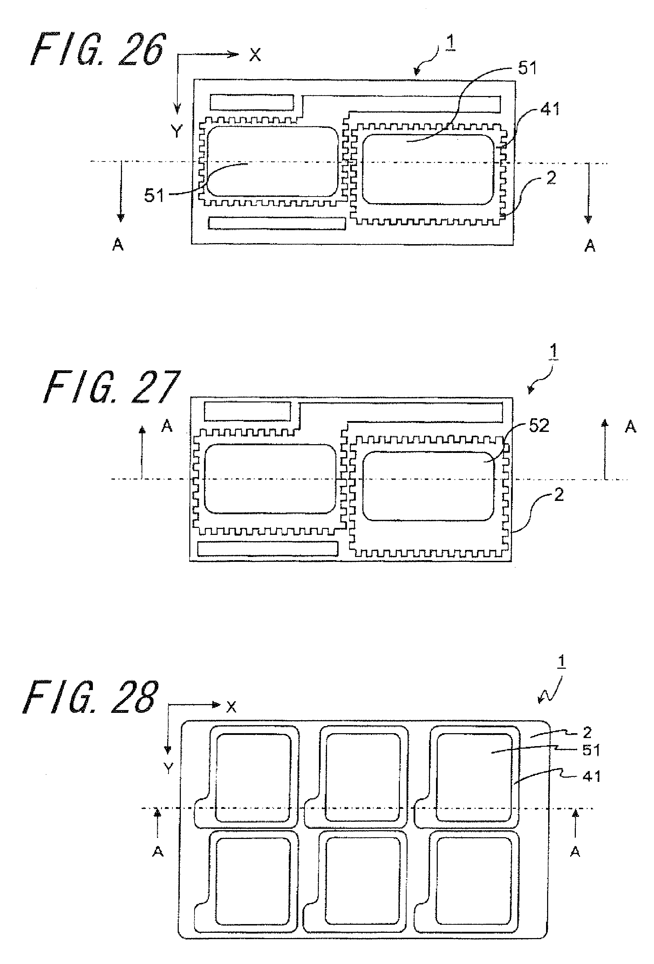

As shown in Figs. 22 to 25, the outer peripheral edge portion of at least a part of the outer layers 41 and 42, the circuit member 51 and the heat dissipating member 52 may have a stepwise shape when viewed from the side, respectively. Furthermore, as shown in Figs. 26 and 27, the outer peripheral edge portion of at least a part of the outer layers 41 and 42, the circuit member 51 and the heat dissipating member 52 may have a concave shape when viewed from the side, respectively. Because volumes of outer peripheral edge portions in which the outer peripheral edge portion of at least a part of the outer layers 41 and 42, the circuit member 51 and the heat dissipating member 52 have a stepwise shape or a concave shape when viewed from the side, respectively, are decreased, thermal stress applied to the supporting substrate 2, generated by the difference in coefficient of thermal expansion among the supporting substrate 2, the outer layers 41 and 42, the circuit member 51 and the heat dissipating member 52 is more easily dispersed. As a result, durability can further be improved.

The heat dissipating base body 1 shown in Figs. 22 to 27 is a heat dissipating base body 1 in which the outer peripheral edge portion of at least a part of the outer layers 41 and 42, the circuit member 51 and the heat dissipating member 52 have a stepwise shape or a concave shape when viewed from the side, respectively. However, the outer peripheral edge portion may have a wave shape, and outer peripheral edge portions having those shapes may be present in a mixed state.

It is preferred in the above heat dissipating base body 1 that the supporting substrate 2 particularly comprises ceramics comprising aluminum oxide as a main component, and the outer layers 41 and 42, the circuit member 51 and the heat dissipating member 52 comprise a metal material comprising copper as a main component. When the supporting substrate 2 comprises ceramics comprising aluminum oxide as a main component, the heat dissipating base body 1 is inexpensive and shows excellent electrically insulating properties. When the circuit member 51 and the heat dissipating member 52 comprise a metal material comprising copper as a main component, the heat dissipating base body 1 can efficiently diffuse heat, and as a result, can combine high reliability and excellent heat dissipating characteristics.

In the case that the supporting substrate 2 comprises ceramics comprising aluminum oxide as a main component, when the elements constituting the supporting substrate 2 are 100% by mass (excluding carbon C and oxygen O), aluminum is preferably contained in an amount of at least 95% by mass or more in terms of aluminum oxide. Magnesium oxide, silicon oxide, cerium oxide and the like may be contained as other addition ingredients. The content of aluminum oxide can be obtained by fluorescent X-ray spectroscopy or ICP (Inductivity Coupled Plasma) emission spectroscopy.

The heat dissipating base body 1 of the present embodiment is preferably configured such that the supporting substrate 2 has three-point bending strength of 450 MPa or more and thermal conductivity of 25 W/(m·K) or more. When the three-point bending strength and thermal conductivity of the supporting substrate 2 fall within those ranges, the heat dissipating base body 1 can improve life and reliability, and particularly can improve creep resistance and durability to heat cycle.

The three-point bending strength and the thermal conductivity may be obtained by removing the circuit member 51 and the heat dissipating member 52 from the heat dissipating base body 1 by polishing or the like, removing the inner layers 31 and 32 and the outer layers 41 and 42 by etching, and the measuring those properties according to JIS R 1601-1995 and JIS R 1611-1997, respectively. In the case that the thickness of the supporting substrate 2 is small and the test piece cut off from the supporting substrate 2 cannot have a thickness of 3 mm, the thickness of the supporting substrate 2 is evaluated as a thickness of the test piece. It is preferred that the result satisfies the above numerical value.

It is preferred as electrical characteristics of the supporting substrate 2 that a volume inherent resistance is $10^{12}$ Ω·m or more at ordinary temperature, and $10^{10}$ Ω·m or more at 300°C. The reason for this is that leakage of current from the circuit member 51 side to the heat dissipating member 52 side during the operations of various electronic components such as a semiconductor element can be inhibited by the supporting substrate 2, and this can prevent electric power loss from being generated, and additionally can reduce electronic device malfunction. The volume inherent resistance of the supporting substrate 2 can be measured using a four-probe method.

The heat dissipating base bodies 1 shown in Figs. 28 to 42 each are heat dissipating base bodies in which the circuit members 51 and the heat dissipating members 52 are sectioned and arranged in plural rows and plural columns respectively in a plan view. Because the circuit members 51 and the heat dissipating members 52 are sectioned and arranged in plural rows and plural columns respectively in a plan view, this heat dissipating base body 1 can form the supporting substrate 2 in a square shape or a rectangle shape close to a square shape, as compared with a heat dissipating base body in which the same number of circuit members are sectioned and arranged in one row or one column. This makes it easy to suppress warpage of the heat dissipating base body 1.

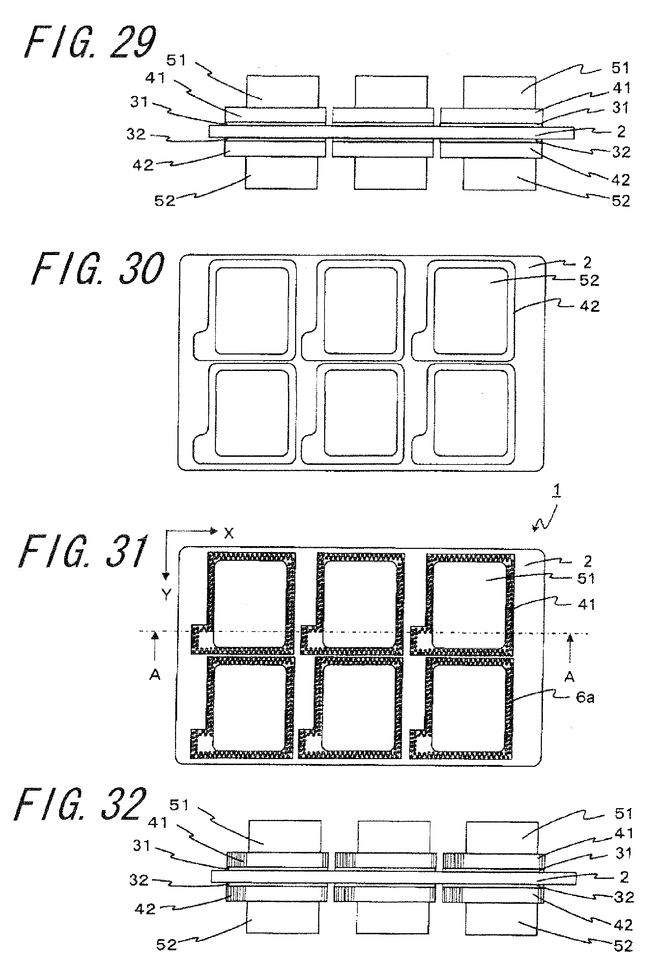

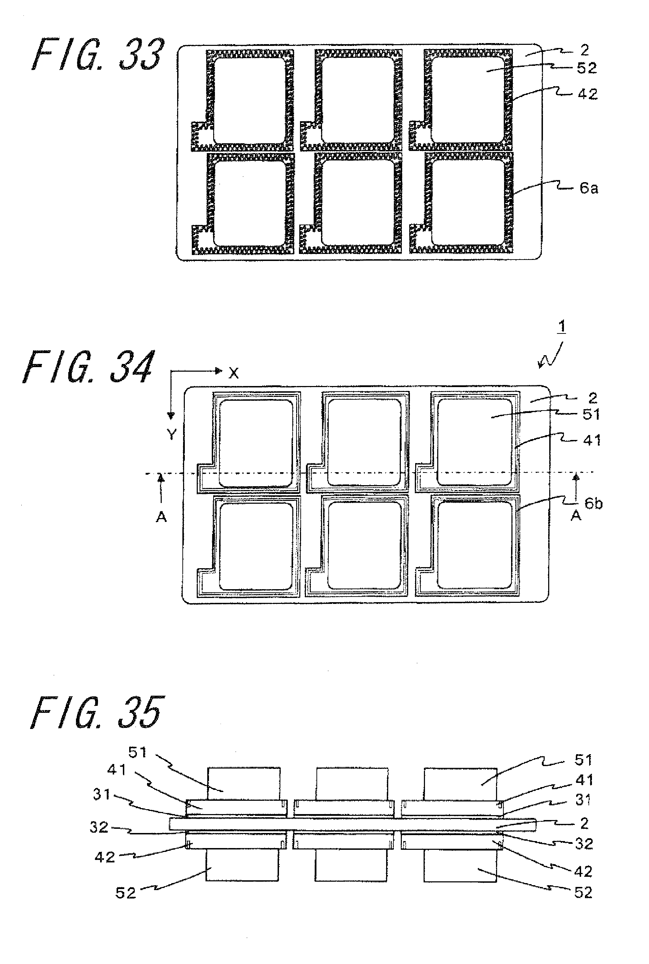

The heat dissipating base body 1 shown in Figs. 31 to 33 is configured such that the outer peripheral edge portions of the outer layers 41 and 42 are equipped with plural columnar through-holes 6a, respectively. The heat dissipating base body 1 shown in Figs. 34 to 36 is equipped with rectangular concave portions 6b in a plan view. The outer layers 41 and 42 are joined toward the circuit member 51 and the heat dissipating member 52 from the supporting substrate 2 through the inner layers 31 and 32, respectively.

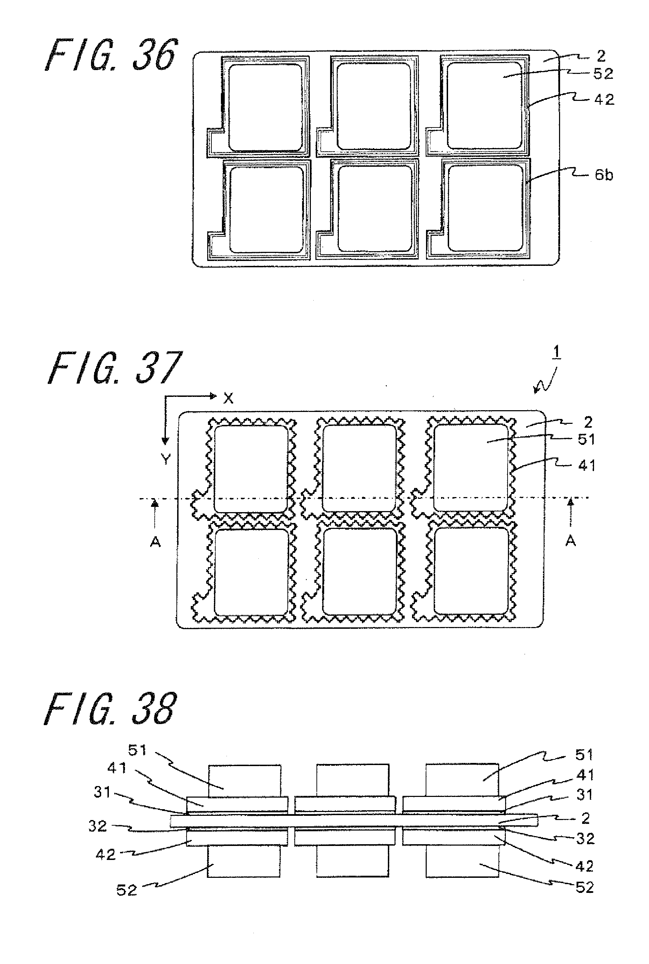

The heat dissipating base body 1 shown in Figs. 37 to 39 is a heat dissipating base body configured such that the outer peripheral edge portions of the outer layers 41 and 42 have plural concave portions, and the outer layers 41 and 42 are joined toward the circuit members 51 and the heat dissipating members 52 from the supporting substrate 2 through the inner layers 31 and 32, respectively.

The heat dissipating base bodies 1 shown in Figs. 31 to 39 are configured such that volumes of the outer peripheral edge portions of the outer layers 41 and 42 are decreased, so that thermal stress applied to the supporting substrate 2, generated by the difference in coefficient of thermal expansion among the supporting substrate 2, the outer layers 41 and 42, the circuit member 51 and the heat dissipating member 52 is more easily dispersed. As a result, durability can further be improved.

The heat dissipating base bodies 1 shown in Figs. 28 to 39 each are heat dissipating base bodies in which the circuit members 51 and the heat dissipating members 52 are sectioned and arranged in two rows and three columns respectively in a plan view. However, it is needless to say that heat dissipating base bodies in which the circuit members 51 and the heat dissipating members 52 are sectioned and arranged in plural rows and plural columns in planer viewing can obtain the same effect as above.

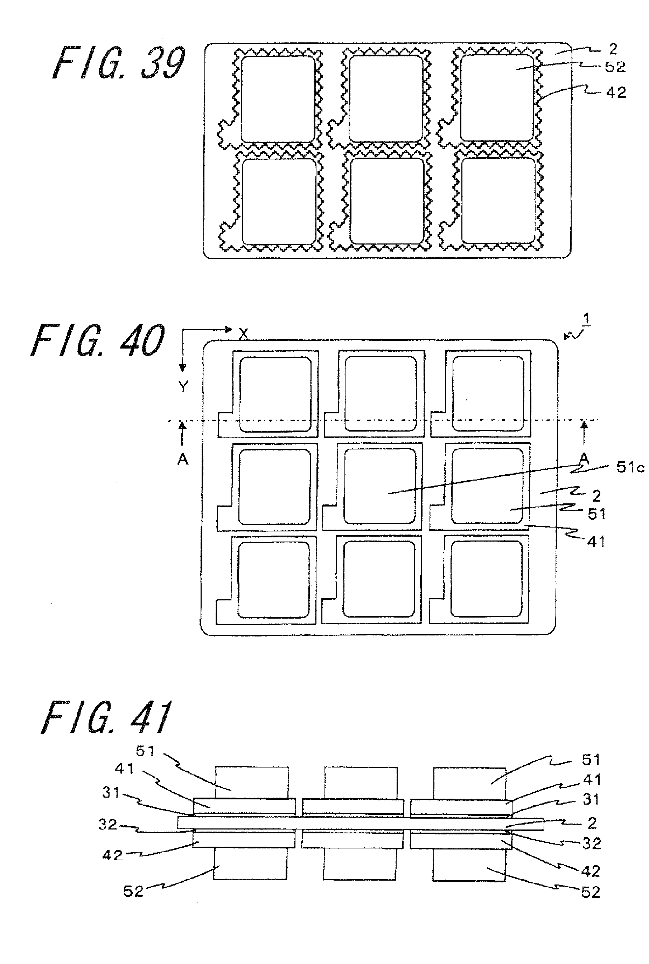

The heat dissipating base body 1 shown in Figs. 40 to 42 is a heat dissipating base body in which the circuit members 51 and the heat dissipating members 52 are sectioned and arranged in odd rows and odd columns in a plan view. Because the circuit members 51 and the heat dissipating members 52 are sectioned and arranged in odd rows and odd columns in a plan view, the heat dissipating base body 1 shown in Figs. 40 to 42 has the structure that the circuit members 51c and the heat dissipating members 52c are arranged on intersections of two diagonal lines connecting four corners when the supporting substrate 2 has a quadrilateral shape. The circuit members 51c and the heat dissipating members 52c restrain deformation of the heat dissipating base body 1, generated in the joining step. This makes it easy to suppress warpage of the heat dissipating base body as a whole.

One example of a production method of the above-described heat dissipating base body is described below. The heat dissipating base body 1 is prepared as follows. First, a supporting substrate 2 comprising, for example, ceramics comprising aluminum oxide as a main component, and having a length in X direction of 30 mm or more and 80 mm or less, a length in Y direction of 10 mm or more and 80 mm or less and a thickness of 0.25 mm or more and 0.65 mm or less is prepared. Metal foils comprising copper (Cu) are arranged on both main surfaces of the supporting substrate 2, followed by heating to 1075°C in vacuum having a degree of vacuum of $1\times10^{-3}$ Pa or less. Thereafter, oxygen gas is introduced into a furnace such that oxygen concentration is 100 ppm, and only surface layer of the metal foil, including a surface of the metal foil contacting the supporting substrate 2 is oxidized, and a eutectic compound as an oxide is precipitated. The inside of the metal foil is not oxidized by the treatment with heating.

The state that the inner layers 31 and 32 and the outer layers 41 and 42 are sequentially laminated from the supporting substrate 2 side is formed by polishing surface layers of metal foils facing the circuit member 51 and the heat dissipating member 52.

To form a stepwise shape, a wave shape or a concave shape when the outer peripheral edge portion of at least one of the outer layers 41 and 42 is viewed from a side, a metal foil having any one of the above shapes previously formed by press processing is used, or the outer layers 41 and 42 are formed and any one of the shapes is then formed by etching.

In order that at least one of the outer layers 41 and 42 comprises the through-hole 6a or the concave portion 6b at a part of the outer peripheral edge portion thereof, a metal foil having the through-hole 6a or the concave portion 6b previously formed by press processing is used. Alternatively, the outer layers 41 and 42 are formed, and the through-hole 6a or the concave portion 6b is then formed by etching. The above can be applied to the case that at least one of the circuit member 51 and the heat dissipating member 52 comprises the through-hole 6a or the concave portion 6b at a part of the outer peripheral edge portion thereof.

In the case that at least a part of the outer peripheral edge portion of at least one of the outer layers 41 and 42 is chamfered, a metal foil previously chamfered by press processing is used, or the outer layers 41 and 42 are formed, followed by chamfering by etching.

Even in the case that the outer peripheral edge potion of at least one of the outer layers 41 and 42 is formed in a stepwise shape, a wave shape or a concave shape when viewed from a side, a metal foil previously formed in any one of the above shapes by press processing is used, or the outer layers 41 and 42 are formed, followed by forming any one of the above shapes by etching.

The circuit members 51 and the heat dissipating members 52, each having a flat face joining to the outer layers 41 and 42, respectively are sectioned and arranged in a matrix such as three rows and two columns, and three rows and three columns. Thereafter, those are heated to 250°C or higher and 500°C or lower in an atmosphere selected from any one of a reducing gas such as hydrogen, an inert gas such as neon or argon, and a mixed gas of nitrogen and hydrogen, and joined under a pressure of 20 MPa or more, thereby obtaining the heat dissipating base body 1. The heat dissipating base body 1 is cooled to a temperature (50°C) at which the circuit member 51 and the heat dissipating member 52 do not oxidize while pressuring. After reaching this temperature, pressurization is stopped, and the heat dissipating base body 1 is taken out. A specific method for forming a circuit on the circuit member 51 and the heat dissipating member 52 may be implemented by using a metal plate comprising any one of copper, a copper alloy, aluminum and an aluminum alloy, having a circuit previously formed thereon by patterning by a method such as press processing, etching processing and wire processing, or subjecting, after joining, the metal plate to patterning by etching, laser or the like.

In the heat dissipating base body 1 obtained by the above production method, at least one of the circuit member 51 and the heat dissipating member 52, and the outer layers 41 and 42 can be joined at low temperature. Therefore, difference between residual stress remaining at the first main surface side and residual stress remaining at the second main surface side is decreased, and as a result, warpage generated in the heat dissipating base body 1 as a whole can be decreased.

An electronic device having an electronic component mounted on the heat dissipating base body is constituted by mounting the electronic component on a circuit member of the heat dissipating base body having small warpage.

Therefore, an electronic device having high reliability, similar to the electronic device shown in Fig. 8 can be obtained.

The heat dissipating base body 1 has high reliability as described above, and therefore can be used over a long period of time without almost decreasing heat dissipating efficiency of heat generated in various electronic components such as semiconductor elements such as an insulated gate bipolar transistor (IGBT) element, a metal-oxide semiconductor field-effect transistor (MOSFET) element, a light-emitting diode (LED) element, a free wheeling diode (FWD) element and a giant transistor (GTR) element; sublimation type thermal printer head elements and thermal inkjet printer head elements.

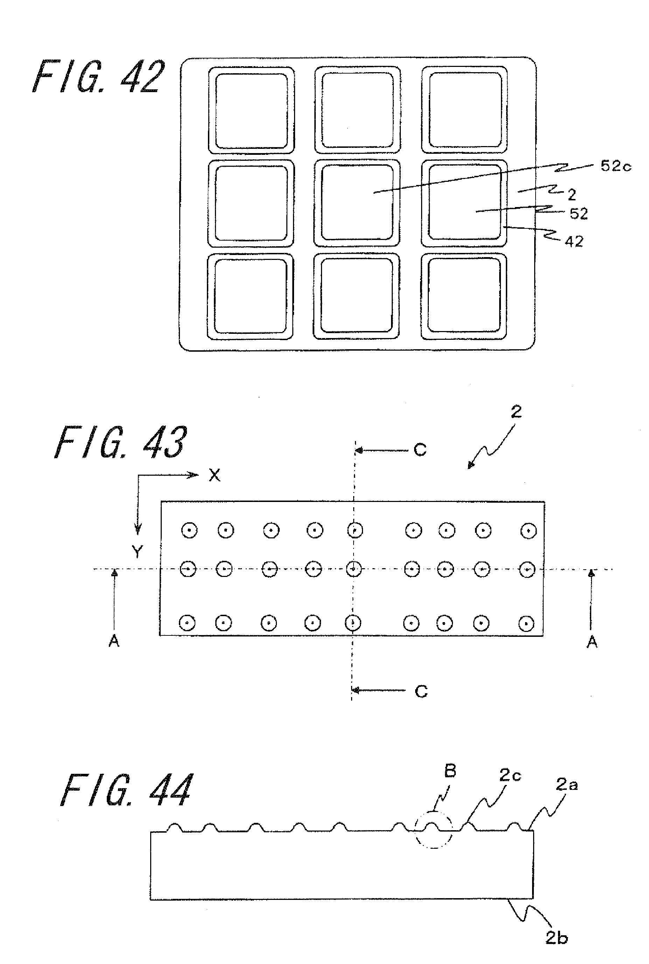

Preferred example of the supporting substrate is described below. The first main surface and the second main surface of the above-mentioned supporting substrate 2 have a planar shape. However, ceramics having a number of depressions (hereinafter referred to as "dimples") having concavities and convexities larger than an average grain size and/or a number of projections having concavities and convexities larger than the average grain size may be used. Specifically, a number of projections 2c having repeated concavities and convexities in given plural directions are formed on at least a first surface 2a of the supporting substrate 2 as shown in Figs. 43 to 46. In this embodiment, a second surface 2b at the back of the first surface 2a has a planar shape.

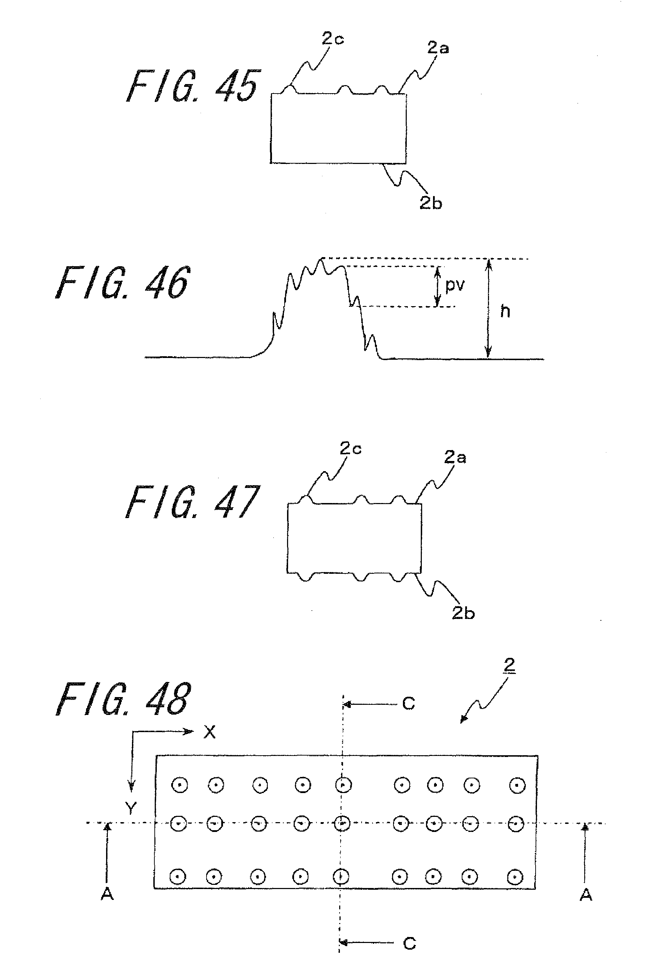

As shown in Fig. 47, the supporting substrate 2 may be configured such that a number of projections 2c having repeated concavo-convex shape in plural directions are formed on the first surface 2a and the second surface 2b which are both main surfaces.

As shown in Figs. 48 to 51, a number of dimples 2d the surface of which has repeated concavo-convex shape in plural directions may be formed on the first surface 2a which is at least one main surface. The second surface 2b which is the other main surface has a planar shape.

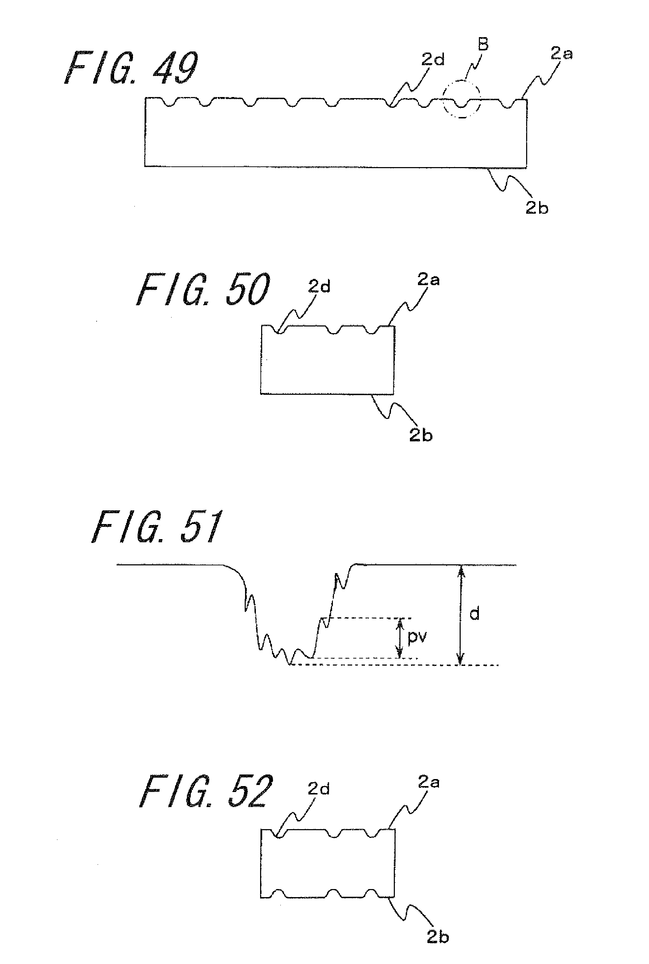

As shown in Fig. 52, there may be used ceramics in which a number of dimples 2d the surface of which has repeated concavo-convex shape in plural directions are formed on the first surface 2a and the second surface 2b which are both main surfaces.

As shown in Figs. 43 to 52, according to the supporting substrate of the present embodiment, a number of the dimples 2d or projections 2c, the surfaces of which has concavo-convex shape larger than the average grain size in plural direction are formed on at least one main surface. Therefore, even though moldings becoming the supporting substrate 2 by firing are piled, followed by firing, the adjacent sintered compacts can easily be separated from each other after firing. When a paste containing a metal is applied to the surface of the sintered compact, followed by heating, high anchor effect is obtained. For example, a metal layer containing, for example, one or more selected from titanium, zirconium, hafnium and niobium can strongly be adhered to the supporting substrate 2.

In Figs. 46 and 51, difference pv in height between the adjacent peak p and valley v, forming concavo-convex shape is 0.5 $\mu$m or more and 8 $\mu$m or less. This difference pv in height is obtained by taking a picture of a cross-section of the supporting substrate 2 with a scanning electron microscope at 2000-fold magnification, and measuring the adjacent peak p and valley v in an optional line having a length in X direction or Y direction of 500 $\mu$m shown in Figs. 43 and 48. The difference pv in height is larger than the average grain size of crystals constituting the supporting substrate 2, and the average grain size of crystals constituting the supporting substrate 2 is, for example, 0.5 $\mu$m or more and 8 $\mu$m or less. The average grain size can be obtained according to JIS R 1670-2006.

A number of the dimples 2d or the projections 2c, constituting repeated concavo-convex shapes in plural directions are preferably formed over the entire surfaces of the main surfaces 2a and 2b of the supporting substrate 2. Each contour of the dimples 2d or the projections 2c may be any one of, for example, a semispherical shape, a spherical dome shape, a spherical zone shape, a circular truncated cone shape, a circular cone shape or a columnar shape. In particular, as shown in Figs. 43 to 52, it is preferred that the surface shape of the dimples 2d or the projections 2c is formed in a semispherical shape. When the surface shape of the dimples 2d or the projections 2c is formed in a semispherical shape, residual stress is difficult to remain in the sintered compact after firing as compared with the shape other than semispherical shape, and as a result, strength is not substantially decreased.

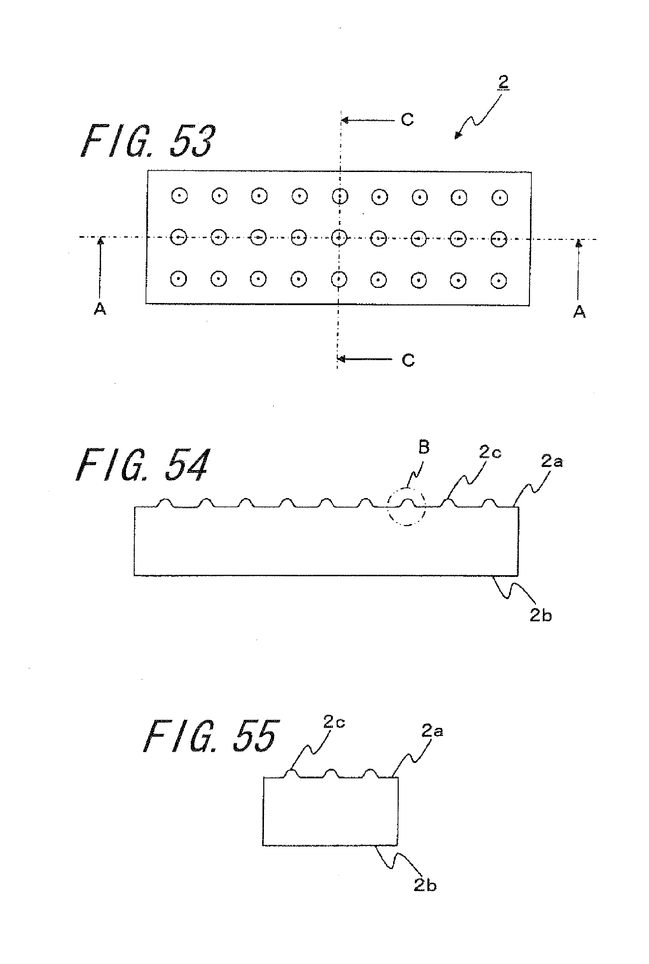

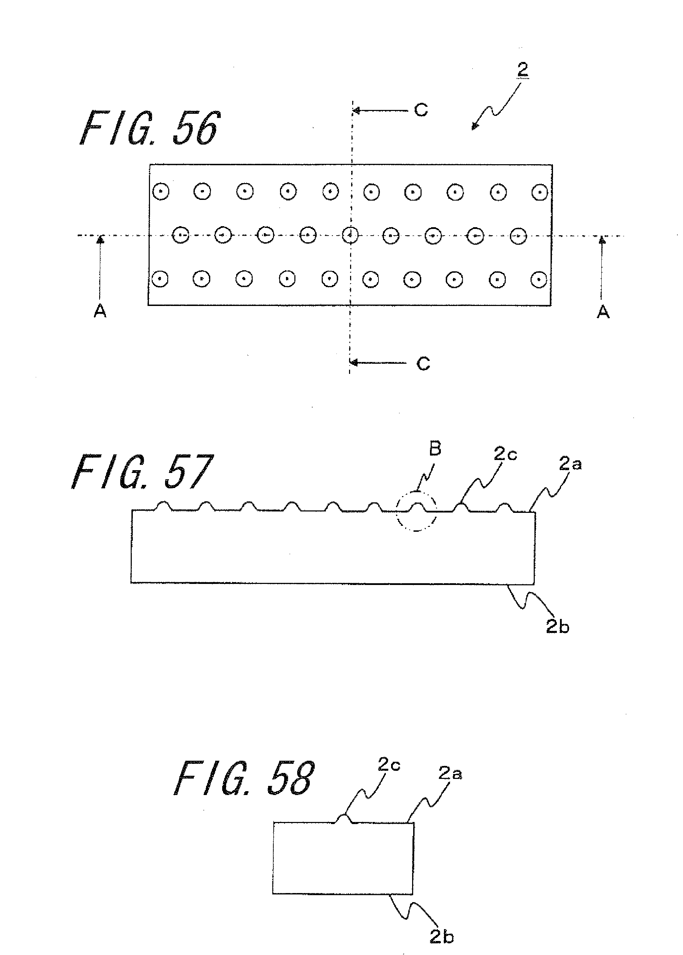

As shown in Figs. 53 to 55, the supporting substrate 2 may be configured such that the projections 2c are arranged side by side at equal interval. As shown in Figs. 56 to 58, the supporting substrate 2 may be configured such that the projections 2c are arranged at equal interval and in a zigzag shape.

When the projections 2c are arranged side by side at equal interval as in the supporting substrate 2c shown in Figs. 53 to 58, the projections 2c have regular arrangement. This arrangement decreases the possibility of partially fixing the adjacent sintered compacts with each other, and as a result, the adjacent sintered compacts can further easily be separated from each other after firing. Even when the dimples 2d, not the projections 2c, are arranged side by side at equal interval, this arrangement also decreases the possibility of partially fixing the adjacent sintered compacts with each other, and as a result, the adjacent sintered compacts can further easily be separated from each other after firing.

By providing a metal layer obtained by applying a paste containing one or more selected from, for example, titanium, zirconium, hafnium and niobium (those metals are hereinafter referred to as "active metals") to the surface of the sintered compact, followed by heating, on the supporting substrates 2 shown in Figs. 43 to 58, the circuit member 22 and the heat dissipating member 23, comprising, for example, copper or an alloy thereof, or aluminum or an alloy thereof can be bonded to the supporting substrate 2 with the metal layer interposed therebetween.

In the case of bonding the circuit member 22 and the heat dissipating member 23 by this method, easiness of peeling of the adjacent sintered compacts with each other after firing and an amount of pores remained in the inside of the metal layer are influenced by a depth d of the dimple 2d and a height h of the projection 2c. In other words, when the depth d and the height h are small, pores are difficult to remain, and when the depth d and the height h are large, the sintered compacts are easily to separate from each other.

According to this supporting substrate 2, the dimple 2d preferably has a depth d of 16 $\mu$m or more and 37 $\mu$m or less. In this case, the adjacent sintered compacts can easily be separated from each other after firing. Additionally, even though a paste containing the active metal is applied to the surface of the sintered compact, air present in the dimples 2d is easily escaped, and as a result, pores do not almost remain in the inside of the metal layer.

According to the supporting substrate of the present embodiment, the projection 2c preferably has a height h of 16 $\mu$m or more and 37 $\mu$m or less. This embodiment can easily separate the adjacent sintered compacts from each other after firing. Furthermore, even though a paste containing the active metal is applied to the surface of the sintered compact, air present between the adjacent projections 2c is easily escaped, and as a result, pores do not almost remain in the inside of the metal layer.

The depth d of the dimples 2d and the height h of the projections 2c are preferably 16 $\mu$m or more and 37 $\mu$m or less. The depth d of the dimples 2d and the height h of projections 2c are obtained by taking a picture of a cross-section of the supporting substrate 2 with a scanning electron microscope at 2000-fold magnification, and measuring the depth and the height in an optional line having a length in X direction or Y direction of 500 $\mu$m shown in Figs. 43 and 48.

Silicon nitride is preferably 80% by mass or more of 100% by mass of the whole components constituting the supporting substrate 2. For example, at least any one of erbium oxide, magnesium oxide, silicon oxide, molybdenum oxide and aluminum oxide may be contained as other component. Mechanical characteristics are preferably such that three-point bending strength is 750 MPa or more, Young's modulus is 300 Gpa or more, Vickers hardness (Hv) is 13 GPa or more, and fracture toughness ($K_{1C}$) is 5 MPam$^{1/2}$ or more. When the mechanical characteristics fall within those ranges, the supporting substrate 2 can improve reliability, that is, creep resistance and durability to heat cycle.

One embodiment of a production method of the supporting substrate is described below. When the main component of the supporting substrate 2 is silicon nitride, a silicon nitride powder in which the proportion of silicon nitride in β-form is 40% or less and an amount z of solute in the compositional formula $Si_{6-z}Al_zO_zN_{8-z}$ is 0.5 or less, and a powder comprising at least any one of erbium oxide, magnesium oxide, silicon oxide, molybdenum oxide and aluminum oxide as an addition ingredient are wet mixed using barrel mill, rotary mill, vibration mill, beads mill, sand mill, agitator mill or the like, followed by pulverization. Thus, a slurry is obtained.

The total of the powder comprising at least any one of erbium oxide, magnesium oxide, silicon oxide, molybdenum oxide and aluminum oxide as an addition ingredient is from 2 to 20% by volume when the sum of the silicon nitride powder and the total of the powders of those addition ingredients is 100% by volume.

Two kinds of α-form and β-form are present in silicon nitride depending on difference in its crystal structure. The α-form is stable at low temperature and the β-form is stable at high temperature. Phase transition of from α-form to β-form irreversibly occurs at 1400°C or higher.

The proportion of β-form is a value calculated by the following formula when the sum of peak strength of α (102) diffraction line and peak strength of α(210) diffraction line, obtained by X-ray diffraction method is $I_\alpha$ and the sum of peak strength of β(101) diffraction line and peak strength of β(210) diffraction line, obtained by X-ray diffraction method is $I_\beta$.

$$\text{Proportion of } \beta\text{-form} = \{I_\beta/(I_\alpha+I_\beta)\}\times100 \ (\%)$$

The proportion of β-form silicon nitride powder affects strength and fracture toughness of the supporting substrate 2. Use of a silicon nitride powder having the proportion of β-form of 40% or less can increase both strength and fracture toughness. In particular, a silicon nitride powder having the proportion of β-form of 10% or less is preferably used, and use of the silicon nitride powder can make an amount of solute z 0.1 or more.

Media used in pulverization of the silicon nitride powder can use media comprising various ceramics such as silicon nitride, zirconia and alumina. Media comprising materials that are difficult to be contaminated by impurities or silicon nitride ceramics having the same material composition are preferred.

The silicon nitride power is preferably pulverized until a particle size ($D_{90}$) in which a cumulative volume is 90% when the sum of cumulative volumes of a particle size distribution curve is 100% is 3 $\mu$m or less, from the improvement of sinterability and needle formation of crystal structure. Particle size distribution obtained by pulverization can be adjusted by an outer diameter of media, an amount of media, viscosity of slurry, pulverization time and the like. To decrease viscosity of slurry, a dispersant is preferably added, and to pulverize in a short time, a powder in which a particle size

($D_{50}$) previously becoming a cumulative volume of 50% is 1 $\mu$m or less is preferably used.

The slurry obtained is passed through a mesh finer than a particle size of 200 mesh and then dried. Thus, granule comprising silicon nitride as a main component (hereinafter referred to as "silicon nitride granule") is obtained. It is preferred for moldability to mix an organic binder such as paraffin wax, polyvinyl alcohol (PVA) or polyethylene glycol (PEG) at the stage of slurry in an amount of 1% by mass or more and 10% by mass or less based on 100% by mass of the powder. The drying may be conducted using a spray drying method using sprayed drier or the like, and other method may be used.

The silicon nitride granule is molded into a sheet using a powder rolling method such as a roll compaction method to form a ceramic sheet, and the ceramic sheet is cut in a given length. Thus, a ceramic compact is obtained. In the case of obtaining the supporting substrate 2 on which dimples 2d the surface of which has repeated concavo-convex shape in plural directions are formed, a network member equipped with projections having repeated concavo-convex shape in plural directions is embossed on a ceramic compact. In the case of obtaining the supporting substrate 2 the surface of which has the projections 2c having repeated concavo-convex shape in plural directions, the slurry previously adjusted to have a given viscosity or more is poured in a syringe, and a given amount of the slurry is dropped on the surface of a ceramic compact from the syringe, followed by drying.

To make the dimple 2d semispherical, a network member equipped with projections having concavo-convex shape in plural directions and having a semispherical shape is used. To make the projection 2c semispherical, viscosity of the slurry dropped on the surface of the ceramic compact is adjusted to 10 Pa·s or more.

To obtain the supporting substrate 2 in which the dimples 2d are arranged side by side at equal interval, a network member in which networks are regularly arranged in, for example, a lattice shape or a zigzag shape is used. To obtain the supporting substrate 2 in which the projections 2c are arranged side by side at equal interval, a plurality of syringes are arranged side by side at equal interval, and a given amount of the slurry is dropped on the surface of a ceramic compact, followed by drying.

To obtain the supporting substrate 2 having a depth d of the dimples 2d of 16 $\mu$m or more and 37 $\mu$m or less, the depth of the dimples in the ceramic compact is adjusted to 20 $\mu$m or more and 46 $\mu$m or less. Similarly, to obtain the supporting substrate 2 having a height h of the projections 2c of 16 $\mu$m or more and 37 $\mu$m or less, the height of the projections in the ceramic compact is adjusted to 20 $\mu$m or more and 46 $\mu$m or less.

A plurality of ceramic compacts thus obtained are laminated in a firing furnace, the atmosphere in the firing furnace is changed to nitrogen atmosphere, and the ceramic compacts are held therein at a temperature of 1700°C or higher and lower than 1800°C for from 1 to 2 hours. Thus, the supporting substrate 2 of the present embodiment can be obtained.

By using the supporting substrate obtained above in a heat dissipating base body and an electronic device, durability can be improved.

Examples

Examples are described below. A paste of a silver (Ag)-copper (Cu) alloy containing titanium (Ti) was applied to both main surfaces of the supporting substrate 2 comprising silicon nitride as a main component by a screen printing method so as to obtain a pattern shown in Fig. 1. The paste was then heated at 870°C in vacuum atmosphere, thereby forming inner layers 31 and 32 each having a thickness of 20 $\mu$m. Outer layers 41 and 42 comprising copper as a main component were formed on both main surfaces of the inner layers 31 and 32 by electroless plating. Resist films (not shown) were printed on both main surfaces of the supporting substrate 2 by a screen printing method such that the circuit member 22 and the heat dissipating member 23 have given patterns. The circuit member 22 and the heat dissipating member 23 each comprising copper as a main component and having a thickness shown in Table 1 were formed on both main surfaces of the outer layers 41 and 42 by electrolytic plating, respectively.

The resist films were peeled by dipping in an alkaline solution, followed by conducting heat treatment such as annealing. Thus, the heat dissipating base body 1 was obtained.

A paste of a silver (Ag)-copper (Cu) alloy containing titanium (Ti), becoming an inner layer was applied to both main surfaces of the supporting substrate comprising silicon nitride as a main component by screen printing. A circuit member and a heat dissipating member were placed on the paste, followed by heating at 800°C and joining. Thus, a heat dissipating base body as a comparative example was obtained.

The maximum height $R_{max}$ in a longitudinal direction of the supporting substrate constituting the heat dissipating member obtained was measured using a stylus surface roughness meter according to JIS B 0601-2001. The measurement value was used as warpage. The cutoff value was not set, and measurement length, radius of a tip of a sensing pit, and scanning rate of a sensing pin were 65 mm, 2 $\mu$m and 1 mm/sec, respectively. Values of warpage measured are shown in Table 1. In Table 1, samples showing a symbol of "-" (minus) mean that concave warpage is generated toward the heat dissipating member, and samples that do not have the symbol in the warpage value mean that convex warpage is generated toward the heat dissipating member.

Table 1

| No | Thickness of circuit member (μm) | Thickness of heat dissipating member (μm) | Warpage (μm) |
|---|---|---|---|
| 1 | 600 | 600 | 62 |
| 2 | 500 | 500 | 53 |
| 3 | 400 | 400 | 48 |
| 4 | 300 | 300 | 46 |
| 5 | 500 | 500 | -162 |
| 6 | 300 | 300 | -105 |

It has been seen from Table 1 that in Sample Nos. 5 and 6 as comparative examples, warpage is concave shape toward the heat dissipating member, and the absolute values are large.

On the other hand, it has been seen that in Sample Nos. 1 to 4, the circuit member 22 and the heat dissipating member 23 comprise the inner layers 31 and 32 and the outer layers 41 and 42 sequentially joined from the supporting substrate 2 side, the inner layers 31 and 32 contain titanium, the outer layer 41 contains copper as a main component, and from those, the warpage is a concave shape toward the heat dissipating member 23, and the absolute value is small.

Reference Signs List

1: HEAT DISSIPATING BASE BODY
2: SUPPORTING SUBSTRATE
10: ELECTRONIC DEVICE
31, 32: INNER LAYER
41, 42: OUTER LAYER
22: CIRCUIT MEMBER
23: HEAT DISSIPATING MEMBER

**Claims**

1. A heat dissipating base body comprising:

   a supporting substrate having a first main surface and a second main surface facing the first main surface;
   a first intermediate layer located on the first main surface;
   a second intermediate layer located on the second main surface;
   a circuit member located on the first intermediate layer; and
   a heat dissipating member located on the second intermediate layer;
   at least one of the first intermediate layer and the second intermediate layer having an inner layer and an outer layer located away from the inner layer to the supporting substrate, and the inner layer having a melting point lower than that of the outer layer.

2. The heat dissipating base body according to claim 1, wherein the inner layer is a metal layer containing one or more selected from titanium, zirconium, hafnium and niobium, and the outer layer is a metal layer containing one or more selected from gold, silver, copper, nickel, cobalt and aluminum.

3. The heat dissipating base body according to claim 1, wherein any reaction layer between a metal contained in the inner layer and a metal contained in the outer layer does not exist between the inner layer and the outer layer.

4. The heat dissipating base body according to claim 1, wherein the inner layer contains molybdenum.

5. The heat dissipating base body according to claim 1, wherein the circuit member and the heat dissipating member comprise copper or an alloy thereof, or aluminum or an alloy thereof.

6. The heat dissipating base body according to claim 1, wherein the supporting substrate comprises ceramics comprising silicon nitride or aluminum nitride as a main component.

7. The heat dissipating base body according to claim 1, wherein at least a part of an edge surface of the inner layer is located further outward than an edge surface of the circuit member or an edge surface of the heat dissipating member.

8. The heat dissipating base body according to claim 1, wherein the inner layer contains an oxide of the main component element of the outer layer, and at least one of the circuit member and the heat dissipating member, and the outer layer comprise the same element as a main component.

9. The heat dissipating base body according to claim 1, wherein the outer layer has a thickness smaller than that of the supporting substrate, the circuit member and the heat dissipating member.

10. The heat dissipating base body according to claim 1, wherein at least one of the circuit member and the heat dissipating member has a thickness larger than that of any one of the supporting substrate, the inner layer and the outer layer.

11. The heat dissipating base body according to claim 1, wherein at least a part of an edge surface of the heat dissipating member is projected outside to an edge surface of the circuit member.

12. The heat dissipating base body according to claim 1, wherein the heat dissipating member has a volume substantially equal to that of the circuit member.

13. The heat dissipating base body according to claim 1, wherein the heat dissipating member has a volume larger than that of the circuit member, and has a projected area larger than that of the circuit member in a plan view.

14. The heat dissipating base body according to claim 1, wherein at least a part of edge surfaces of the circuit member and the heat dissipating member is located further inward than the edge surfaces of the inner layer and the outer layer.

15. The heat dissipating base body according to claim 1, wherein at least one of the outer layer, the circuit member and the heat dissipating member comprises a through-hole or a concave portion at a part of an outer peripheral edge portion thereof.

16. The heat dissipating base body according to claim 1, wherein the supporting substrate comprises ceramics comprising aluminum oxide as a main component, and the outer layer, the circuit member and the heat dissipating member comprise a metal material comprising copper as a main component.

17. The heat dissipating base body according to claim 1, wherein the supporting substrate is ceramics comprising depressions having concavities and convexities larger than an average grain size, and/or projections having concavities and convexities larger than an average grain size.

18. An electronic device comprising the heat dissipating base body according to claim 1, and an electronic component mounted on the circuit member of the heat dissipating base body.

*FIG. 1*

*FIG. 2*

*FIG. 3*

*FIG. 4*

*FIG. 5*

*FIG. 6*

*FIG. 7*

*FIG. 8*

*FIG. 9*

*FIG. 10*

51
41
42
52

B

1

2

*FIG. 11*

1

51
41
31
2
32
42
52

*FIG. 12*

42
1
52
2

A

A

FIG. 13

FIG. 14

FIG. 15

*FIG. 16*

(a)

51

41

51

6a

2

A

A

*FIG. 17*

1

A

A

52

2

6a

*FIG. 18*

1

51

41

51

6b

2

A

A

*FIG. 19*

(d)

1

A

A

52

2

6b

*FIG. 20*

X

Y

1

51

41

(a)

51

2

A

A

*FIG. 21*

(d)

1

A

A

52

2

*FIG. 22*

*FIG. 23*

*FIG. 24*

*FIG. 25*

*FIG. 26*

*FIG. 27*

*FIG. 28*

## FIG. 29

## FIG. 30

## FIG. 31

## FIG. 32

*FIG. 33*

*FIG. 34*

*FIG. 35*

FIG. 36

FIG. 37

FIG. 38

*FIG. 39*

*FIG. 40*

*FIG. 41*

*FIG. 42*

*FIG. 43*

*FIG. 44*

FIG. 45

2c    2a

2b

FIG. 46

pv

h

FIG. 47

2c    2a

2b

FIG. 48

2

C

X

Y

A                                                    A

C

EP 2 284 883 A1

*FIG. 49*

2d    B    2a

2b

*FIG. 50*

2d    2a

2b

*FIG. 51*

d

pv

*FIG. 52*

2d    2a

2b

32

## FIG. 53

## FIG. 54

## FIG. 55

FIG. 56

FIG. 57

FIG. 58

| INTERNATIONAL SEARCH REPORT | International application No. |
|---|---|
| | PCT/JP2009/058177 |

**A. CLASSIFICATION OF SUBJECT MATTER**
*H01L23/36*(2006.01)i, *H01L23/12*(2006.01)i

According to International Patent Classification (IPC) or to both national classification and IPC

**B. FIELDS SEARCHED**

Minimum documentation searched (classification system followed by classification symbols)
H01L23/36, H01L23/12

Documentation searched other than minimum documentation to the extent that such documents are included in the fields searched
Jitsuyo Shinan Koho 1922-1996 Jitsuyo Shinan Toroku Koho 1996-2009
Kokai Jitsuyo Shinan Koho 1971-2009 Toroku Jitsuyo Shinan Koho 1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2007-227867 A (Kyocera Corp.), 06 September, 2007 (06.09.07), | 1-3,5-14,16, 18 |
| Y | Full text; all drawings (Family: none) | 4,15,17 |
| Y | JP 7-202063 A (Toshiba Corp.), 04 August, 1995 (04.08.95), Par. Nos. [0019] to [0026] & US 5672848 A & KR 10-0147881 B | 4 |
| Y | JP 10-84059 A (Toshiba Corp.), 31 March, 1998 (31.03.98), Full text; all drawings (Family: none) | 15 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 June, 2009 (11.06.09) | 23 June, 2009 (23.06.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2009/058177 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2003-101217 A (Kyocera Corp.),<br>04 April, 2003 (04.04.03),<br>Full text; all drawings<br>(Family: none) | 17 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5148053 A
- JP 9069590 A
- JP 5090444 A